# EUROPEAN PATENT SPECIFICATION

(11) **EP 1 786 091 B1**
(45) Date of publication and mention of the grant of the patent: **17.03.2010**
(21) Application number: 05758234.8
(22) Date of filing: 05.07.2005
(51) Int. Cl.: H01L 41/09, H02N 2/00, G02B 7/08, G04C 3/12

(54) **PIEZOELECTRIC ACTUATOR AND DEVICE**
PIEZOELEKTRISCHER AKTUATOR UND EINRICHTUNG
ACTIONNEUR PIÉZOÉLECTRIQUE ET DISPOSITIF

(30) Priority: 07.07.2004 JP 2004200794
(43) Date of publication of application: 16.05.2007
(73) Proprietor: Seiko Epson Corporation, Tokyo 163-0811 (JP)
(72) Inventor: NAGAHAMA, Reiko, Suwa-shi, Nagano 3928502 (JP); YAMAZAKI, Yutaka, Suwa-shi, Nagano 3928502 (JP)
(74) Representative: HOFFMANN EITLE
(86) International application number: PCT/JP2005/012389
(87) International publication number: WO 2006/004108

(56) References cited:
- WO-A1-02/078164
- WO-A1-03/077410
- JP-A- 2000 004 590
- JP-A- 2002 291 264
- JP-A- 2003 304 693
- JP-A- 2004 166 479
- US-A- 6 104 123

## Description

### Technical Field

The present invention relates to a piezoelectric actuator for driving a driven member by oscillating a piezoelectric element, and an apparatus including the piezoelectric actuator.

### Background Art

As a piezoelectric actuator that drives a driven member by oscillating a piezoelectric element, there is a piezoelectric actuator in which a plurality of oscillation modes are simultaneously excited and the driven member is driven by a combination of the oscillation mode. In this piezoelectric actuator, in order to obtain a predetermined oscillating path or drive force, an oscillating component of each oscillating mode needs to be appropriately held. In order to achieve this, a method of controlling a drive signal using the phase difference between the drive signal applied to the piezoelectric element and a detection signal detected by the oscillation of the piezoelectric element has been suggested (for example, see Patent Document 1).
In this piezoelectric actuator, a detection electrode is provided in the piezoelectric actuator, and a phase difference between the drive signal applied to the piezoelectric element and the detection signal detected by the detection electrode is monitored. In addition, a drive frequency of a drive signal that is applied to the piezoelectric element is adjusted such that a phase difference becomes a predetermined value.
Therefore, an oscillation component in each oscillation mode in the piezoelectric actuator is appropriately controlled, and efficient driving is performed.

[Patent Document 1] JP-A-2002-291264 (see pages 12 and 13, and Figs. 26 and 27).
[Patent Document 1]

US 2004/0080243 A1 pertains to a rotation/displacement converting actuator having an actuator unit constituted by a displacing body and an actuator in which the displacing body can be linearly displaced. US 2002/0171410 A1 pertains to a piezoactuator and a drive circuit therefore, the piezoactuator having a diaphragm and the diaphragm has flat piezoelectric elements that oscillate in a longitudinal oscillation mode and a sinusoidal oscillation mode.

### Disclosure of the Invention

### Problems that the Invention is to Solve

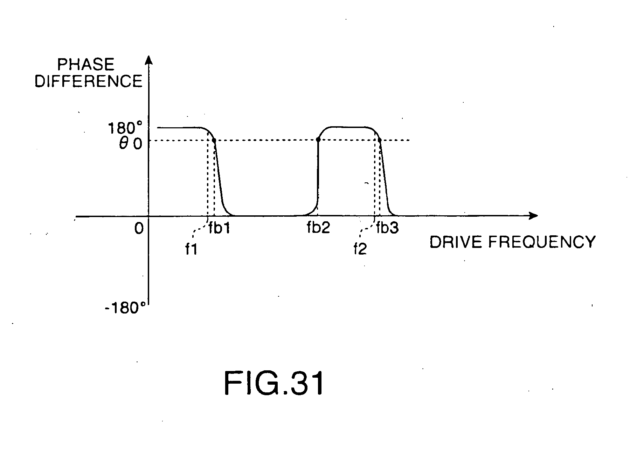

However, in the piezoelectric actuator disclosed in Patent Document 1, since an oscillation in a plurality of oscillation modes is simultaneously detected by using a detection signal detected by the detection electrode, a phase difference varies near a resonance frequency of oscillation in each of the plurality of oscillation modes, and a plurality of oscillation frequencies may exist with respect to a predetermined phase difference that is an optimal phase difference.
For example, Fig. 31 shows a characteristic of a phase difference with respect to a drive frequency in the piezoelectric actuator disclosed in Patent Document 1. The piezoelectric actuator has a longitudinal primary oscillation mode in which the piezoelectric element expands and contracts in a longitudinal direction of the piezoelectric element and a flexural secondary oscillation mode in which flexural oscillation is created in a direction substantially perpendicular to an oscillation direction in the longitudinal primary oscillation mode, and a phase difference increases near resonance frequencies f1 and f2 of oscillation in each oscillation mode, as shown in Fig. 31. Accordingly, a plurality of drive frequencies (in Fig. 31, three drive frequencies fb1, fb2, and fb3) exist with respect to a predetermined phase difference θ0 to be controlled.
In this case, even though the drive frequency is controlled such that the phase difference becomes a predetermined value θ0, a drive frequency cannot be determined to a single value. Therefore, an oscillation component ratio in a predetermined oscillation mode may not be obtained, and the reliability of a drive performance in the piezoelectric actuator may be lowered.

### Disclosure of the Invention

Accordingly, an object of the present invention is to provide a piezoelectric actuator and an apparatus that are capable of improving reliability of a drive performance.

### Means for Solving the Problem

A piezoelectric actuator according to claim 1 drives a driven member by oscillating a piezoelectric element having two or more oscillation modes. The piezoelectric actuator includes a drive electrode that applies a drive signal to the piezoelectric element so as to oscillate the piezoelectric element, a detection electrode that detects an oscillation behavior of the piezoelectric element, and a control unit that controls the a drive signal on the basis of a phase difference between the drive signal applied to the drive electrode and a detection signal detected by the detection electrode. The detection electrode is formed at a location where the phase difference due to an oscillation mode other than a mainly used oscillation mode is less than a target phase difference at the time of controlling.
According to the invention, since the detection electrode is formed at a location where the phase difference due to an oscillation mode other than a mainly used oscillation mode is less than the target phase difference, the phase difference only due to the mainly used oscillation mode becomes the target phase difference. Therefore, since a drive frequency with respect to the target phase difference is determined to a single value, it is possible to adjust an optimum drive signal by controlling a frequency of the drive signal. Accordingly, even in a piezoelectric actuator having a plurality of oscillation modes, each oscillation component is appropriately adjusted, and thus the reliability of a drive performance can be improved.

Further, since the detection electrode mainly detects the oscillation by the mainly used oscillation mode, the oscillation in the necessary oscillation mode can be directly controlled, and thus the piezoelectric actuator can be accurately controlled.
In this case, when there are three or more oscillation modes, the detection electrode may be formed at a location where the phase difference due to all of the oscillation modes other than the mainly used oscillation mode is less than the target phase difference.

It is preferable that the detection electrode is formed at a location where the phase difference due all of the oscillation modes other than the mainly used oscillation mode is 20° or less.
A general feature of the piezoelectric actuator is that when the phase difference increases, the number of rotation increases, but when the phase difference decreases, consumption electricity is lowered. One of the number of rotation and the consumption electricity is determined to be focused in the target phase difference according to the product specification. However, when the phase difference much deceases in order to lower the consumption electricity, the piezoelectric actuator cannot be driven. The lowest limit of the target phase difference is set to be 20° or so. Accordingly, when the phase difference due to the oscillation mode other than the mainly used oscillation mode is 20° or less, the piezoelectric actuator is applicable in most products and may be corresponded to several product specifications.

The piezoelectric actuator drives a driven member by oscillating a piezoelectric element having two or more oscillation modes. The piezoelectric actuator includes a drive electrode that applies a drive signal to the piezoelectric elements so as to oscillate the piezoelectric element, a detection electrode that detects an oscillation behavior of the piezoelectric element, and a control unit that controls the drive signal on the basis of a level of a signal detected by the detection electrode. The detection electrode is formed at a location where the level of the signal due to an oscillation mode other than a mainly used oscillation mode is less than a target level of the signal at the time of controlling.
Since the detection electrode is formed at a location where the level of the signal due to an oscillation mode other than a mainly used oscillation mode is less than the target level of the signal, the level of the signal only due to the mainly used oscillation mode becomes the target level of the signal. Therefore, since a drive frequency with respect to the target level of the signal is determined to a single value, it is possible to adjust an optimum drive signal by controlling a frequency of the drive signal. Accordingly, even in a piezoelectric actuator having a plurality of oscillation modes, each oscillation component is appropriately adjusted, and thus the reliability of a drive performance can be improved.

It is preferable that the detection electrode is formed at a location where expanding part and contracting part due to an oscillation mode other than the mainly used oscillation mode occur at the same time, and thus electric charge occurring at the respective part is offset.
When contracted, the piezoelectric element generates positive current, and when expanded, the piezoelectric element generates negative current. Accordingly, when the detection electrode is formed at a location (where occurring at the same time) where the expanding part and contracting part due to the oscillation mode other than the mainly used oscillation mode occur concurrently, the positive and negative currents are offset each other, and thus the level of the detection signal decreases. At the same time, the phase difference between the drive signal and the detection signal seen near a resonance frequency decreases.
Accordingly, since electric charges due to the expansion and contraction are offset in the detection electrode where the expansion and contraction parts due to the oscillation mode other than the mainly used oscillation mode concurrently occur so that the phase difference or the level of the detection signal due to the oscillation mode becomes small value, it may be surely suppressed to be less than the target phase difference or the target level of the signal.

It is preferable that the detection electrode is formed at a location including a location where strain due to an oscillation mode other than a mainly used oscillation mode becomes minimized.
Since the detection electrode is formed at a location including a location where strain due to an oscillation mode other than a mainly used oscillation mode becomes minimized, the oscillation behavior that is detected by the detection electrode becomes an oscillation behavior in which an influence due to the oscillation in the oscillation mode other than the mainly used oscillation mode is suppressed to be minimized, and which mainly becomes the oscillated by the mainly used oscillation mode. Accordingly, when the phase difference or the level of the detection signal at which the oscillation component in the mainly used oscillation mode becomes appropriate is set to a predetermined value, a single value of a drive signal with respect to the phase difference or the level of the detection signal is determined. Thus, the control unit controls the drive signal on the basis of the phase difference, so that the drive signal can be optimally adjusted. Accordingly, even in a piezoelectric actuator having a plurality of oscillation modes, each oscillation component is appropriately adjusted, and the reliability of a drive performance can be improved.

It is preferable that the oscillation mode includes a longitudinal oscillation mode in which the piezoelectric element expands and contracts in a predetermined direction, and a flexural oscillation mode in which flexural oscillation is created in a direction substantially perpendicular to an oscillation direction of the longitudinal oscillation mode, and the detection electrodes be formed at locations including an node of an oscillation in the flexural oscillation mode.
According to this disclosure, the oscillation mode includes the longitudinal oscillation mode and the flexural oscillation mode. In general, since a drive force is strong in the longitudinal oscillation mode rather than the flexural oscillation mode, the longitudinal oscillation mode is set to the mainly used oscillation mode, and thus a strong drive force is obtained. In this case, since the detection electrode is formed at the locations including the node of the oscillation in the flexural oscillation mode, the strain due to the oscillation in the flexural oscillation mode becomes minimized. Accordingly, the detection electrode mainly detects the oscillation behavior in the longitudinal oscillation mode, and accurate control based on the oscillation behavior in the longitudinal oscillation mode can be performed. As a result, it is possible to surely ensure an appropriate drive force by the oscillation in the longitudinal oscillation mode.

It is preferable that the piezoelectric element be formed in substantially a rectangular shape, the oscillation mode includes a longitudinal primary oscillation mode in which the piezoelectric element expands and contracts along a longitudinal direction of the piezoelectric element, and a flexural secondary oscillation mode in which flexural oscillation is created in a direction substantially perpendicular to an oscillation direction of the longitudinal primary oscillation mode, and the detection electrode be formed at a location including an node of an oscillation in the longitudinal primary oscillation mode and an node of an oscillation in the flexural secondary oscillation mode.
Since the oscillation mode includes a longitudinal primary oscillation mode and a flexural secondary oscillation mode, the entire piezoelectric element oscillates while describing an oscillation path that combines the oscillation in the longitudinal primary oscillation mode and the flexural secondary oscillation mode. At this time, the detection electrode is formed at a location including the node of the oscillation in the longitudinal primary oscillation mode and the node of the oscillation in the flexural secondary oscillation mode. At these locations, the strain due to the oscillation in the longitudinal primary oscillation mode becomes maximized, and the strain due to the oscillation in the flexural secondary oscillation mode becomes minimized. Accordingly, in the detection electrode, the oscillation behavior by the oscillation in the longitudinal primary oscillation mode is mainly detected, and accurate control based on the oscillation behavior in the longitudinal primary oscillation mode is performed. Accordingly, a proper oscillation component of a longitudinal primary oscillation mode is obtained, and a necessary drive force is surely ensured.

It is preferable that the piezoelectric actuator be constructed such that an oscillation direction of the flexural oscillation mode is changed to a forward direction and a backward direction.
Since the piezoelectric actuator is constructed such that the oscillation direction of the flexural oscillation mode can be changed to a forward direction and a backward direction, the oscillation path can change forward and backward, and the driven member can be driven in forward and backward directions. As a result, an operation range in which the driven member can be driven can be widened. Further, even in this case, since the detection electrode is formed at locations including the location of the node of the flexural oscillation mode, the excellent oscillation behavior in the longitudinal oscillation mode is detected, even when the oscillation direction of the flexural oscillation mode can be changed to a forward direction and a backward direction.
In this case, the flexural oscillation mode may include a flexural secondary oscillation mode. Further, the longitudinal oscillation mode may include a longitudinal primary oscillation mode.

Preferably, an area of the detection electrode is 1/30th or more and 1/7th or less of an area of the drive electrode.
Since the the area of the detection electrode is appropriately set, the area of the detection electrode necessary for oscillation detection can be ensured, and since the area of the drive electrode does not become excessively small, the excellent drive force of the piezoelectric actuator can be ensured.
In this case, when the area of the detection electrode is smaller than 1/30th of the area of the drive electrode, the area of the detection electrode itself becomes excessively smaller, which does not surely detect the oscillation of the piezoelectric element. Further, when the area of the detection electrode is larger than 1/7th of the area of the drive electrode, the area of the drive electrode becomes relatively smaller. As a result, it becomes difficult to ensure a necessary drive force, and the oscillation in the oscillation mode other than the mainly used oscillation mode is also easily detected, which lowers the accuracy of the detection signal.

An apparatus according to claim 9 includes the above-described piezoelectric actuator.
Since the apparatus includes the above-described piezoelectric actuator, it is possible to obtain the same effect as the above-described piezoelectric actuator. That is, since a drive signal with respect to the phase difference or the level of the detection signal between the drive signal and the detection signal is determined to a single value, when the control unit controls the phase difference such that the phase difference has a predetermined value, the drive signal is always held to a constant value. Each of the oscillation components of the plurality of oscillation modes is appropriately controlled, and the reliability of the drive performance is improved. As a result, the operation of the apparatus can be stabilized.

It is preferable that the apparatus further include lenses, and a drive unit that drives the lenses by oscillating the piezoelectric actuator.
Since the apparatus includes the drive unit that drives the lenses by oscillating the piezoelectric actuator, the lens can be reliably driven. This is advantageous in particular in the following case. For example, when the apparatus is a small-size apparatus, such as a cellular phone or the like, the lens also has a small size, but the piezoelectric actuator can generate a relatively strong drive force with a small size.

It is preferable that the apparatus be a timepiece that is driven by oscillating the piezoelectric actuator.
The apparatus may be a timepiece, and the timepiece is driven by the oscillation of the above-described piezoelectric actuator.
Therefore, it is possible to obtain the same effect as the above-described piezoelectric actuator. Each of the oscillation components of the plurality of oscillation modes is appropriately controlled, and the reliability of the drive performance of the timepiece is improved. This is advantageous in particular in the following case. For example, when the timepiece has a small size as in a wristwatch and the like, the piezoelectric actuator can generate a relatively strong drive force with a small size.

According to the piezoelectric actuator and the apparatus, since the detection electrodes are formed at locations including the locations where the phase difference or the level of the detection signal due to the oscillation mode other than the mainly used oscillation mode becomes less than the target phase difference or the target level of the signal, the detection electrodes can mainly detect the oscillation behavior in the mainly used oscillation mode. Further, since a drive signal with respect to the appropriate phase difference or the level of the detection signal is determined to a single value, the control unit can appropriately and surely control the drive signal. Therefore, it is possible to obtain an effect in which the reliability of the drive performance can be improved.

### Brief Description of the Drawings

Fig. 1 is a perspective view showing a lens unit according to a first embodiment of the invention.
Fig. 2 is a perspective view showing the lens unit according to the first embodiment.
Fig. 3A is an operational diagram of a cam member according to the first embodiment.
Fig. 3B is an operational diagram of a cam member according to the first embodiment.
Fig. 4A is an operational diagram of the cam member according to the first embodiment.
Fig. 4B is an operational diagram of the cam member according to the first embodiment.
Fig. 5 is an enlarged perspective view of a piezoelectric actuator according to the first embodiment.
Fig. 6 is a structural block diagram of an applying device according to the first embodiment.
Fig. 7 is a diagram showing the phase difference between a drive signal and a detection signal according to the first embodiment.
Fig. 8 is a diagram showing a relationship between a phase difference and a drive speed with respect to a drive frequency according to the first embodiment.
Fig. 9 is a diagram showing a timepiece according to a second embodiment of the invention.
Fig. 10 is an enlarged view showing a piezoelectric actuator according to the second embodiment.
Fig. 11 is a plan view showing locations of piezoelectric elements according to the second embodiment.
Fig. 12 is a plan view showing state of piezoelectric elements according to the second embodiment.
Fig. 13 is a diagram showing a phase difference and a drive speed of a drive frequency according to the second embodiment.
Fig. 14A is a diagram showing a modification of a detection electrode of a piezoelectric actuator.
Fig. 14B is a diagram showing a modification of a detection electrode of a piezoelectric actuator.
Fig. 14C is a diagram showing a modification of a detection electrode of a piezoelectric actuator.
Fig. 14D is a diagram showing a modification of a detection electrode of a piezoelectric actuator.
Fig. 14E is a diagram showing a modification of a detection electrode of a piezoelectric actuator.
Fig. 14F is a diagram showing a modification of a detection electrode of a piezoelectric actuator.
Fig. 15 is a diagram showing a modification of a detection electrode of a piezoelectric actuator.
Fig. 16 is a diagram showing a modification of a detection electrode of a piezoelectric actuator.
Fig. 17 is a graph showing a relationship between a phase difference, the number of rotation, and a consumption electric power with respect to a drive frequency of a piezoelectric actuator.
Fig. 18 is a graph showing a relationship between a level of detection signals, the number of rotation, and a consumption electric power with respect to a drive frequency of a piezoelectric actuator.
Fig. 19 is a diagram showing the piezoelectric actuator according to the first embodiment of the invention.
Fig. 20 is a diagram showing the piezoelectric actuator according to a comparative example of the invention.
Fig. 21 is a diagram showing the results of the first embodiment.
Fig. 22 is a diagram showing the results of the comparative example.
Fig. 23 is a diagram show the specific result of the phase difference according to the second embodiment of the invention.
Fig. 24 is a diagram show the specific result of the detection signal according to the second embodiment of the invention.
Fig. 25 is a diagram show the specific result of the phase difference according to the second embodiment of the invention.
Fig. 26 is a diagram show the specific result of the detection signal according to the second embodiment of the invention.
Fig. 27 is a diagram show the specific result of the phase difference according to the second embodiment of the invention.
Fig. 28 is a diagram show the specific result of the detection signal according to the second embodiment of the invention.
Fig. 29 is a diagram show the specific result of the phase difference according to the second embodiment of the invention.
Fig. 30 is a diagram show the specific result of the detection signal according to the second embodiment of the invention.
Fig. 31 is a diagram showing phase difference characteristics with respect to the drive frequency of a piezoelectric actuator according to the related art.

### Reference Numerals

1 DRIVE DEVICE (DRIVE UNIT), 9 ... TIMEPIECE (APPARATUS), 10 ... LENS UNIT, 30, 40, 50 ... LENS (DRIVEN MEMBER), 66, 76 ... OSCILLATING MEMBER (PIEZOELECTRIC ACTUATOR), 82, 111A, 111B ... PIEZOELECTRIC ELEMENT, 82A, 82B, 101B, 102A, 103A, 112A, 113A, 114A, 112B, 113B, 114B ... DRIVE ELECTRODE, 82C, 101A, 101C, 101D, 101E, 101F, 102B, 115A, 912B ... DETECTION ELECTRODE, 84 ... APPLYING DEVICE (CONTROL UNIT), 91, 100A, 100B, 100C, 100D, 100E, 100F, 110A, 110B ... PIEZOELECTRIC ACTUATOR, 92 ... ROTOR (DRIVEN MEMBER)

### Best Mode for Carrying Out the Invention

Preferred embodiments of the invention will now be described in detail with reference to the accompanying drawings. In second and subsequent embodiments to be described below, the same components and components having the same functions as constituent components in a first embodiment described below are denoted by the same reference numerals, and the description thereof are simplified or omitted.

### [First Embodiment]

Hereinafter, a lens unit 10 according to a first embodiment of the invention will be described. Further, the lens unit 10 is mounted in a camera as an apparatus, or is manufactured and used integrally with the camera.
In addition to the lens unit 10, the camera also includes a recording medium to record images created by lenses 30, 40, and 50 that form the lens unit 10, a drive device 1 serving as a drive unit for driving the lenses 30, 40, and 50, and a case in which all of these components are accommodated. However, the camera, the storage medium, and the case are omitted in the drawings.

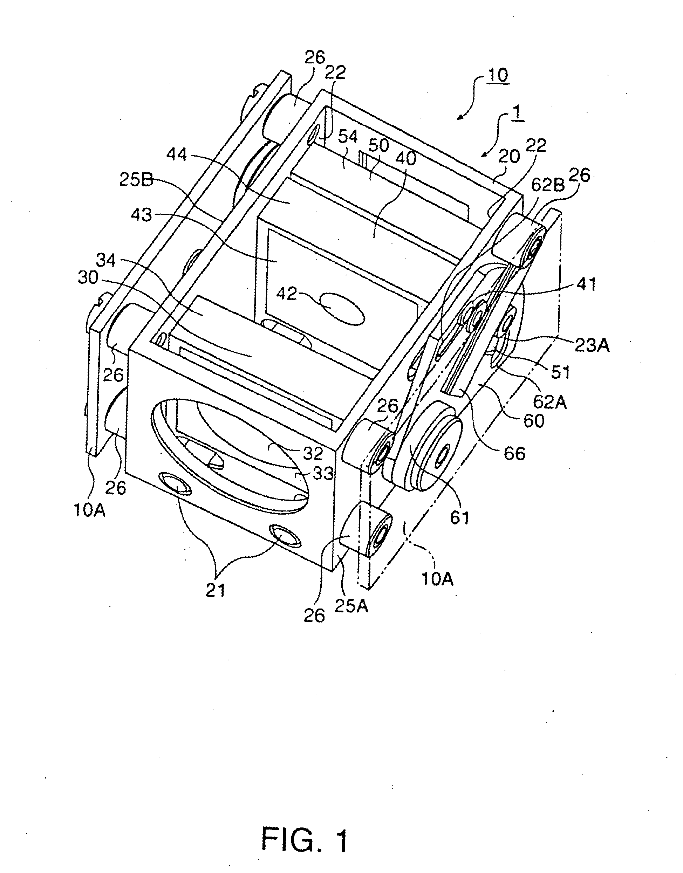

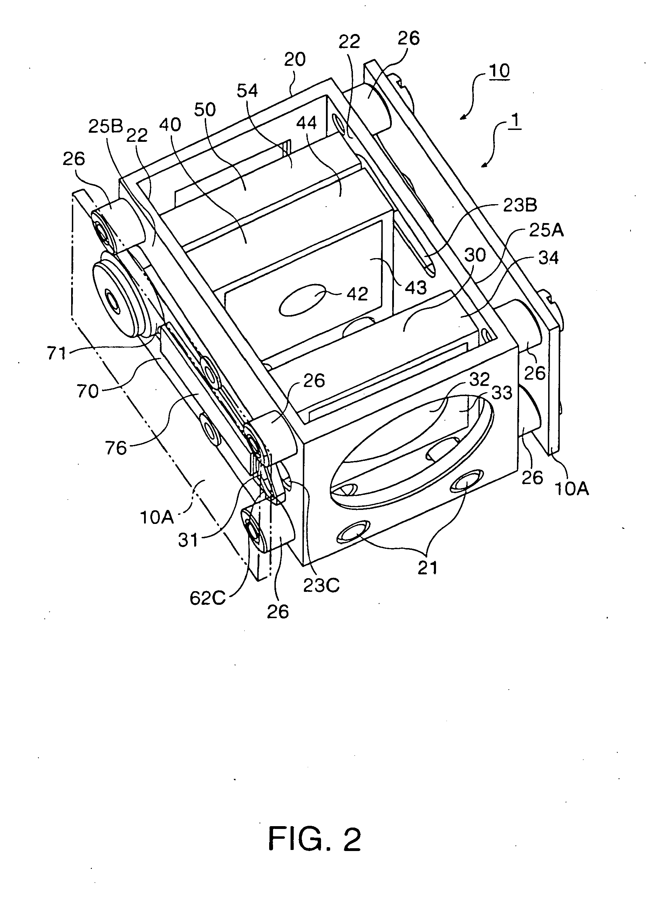

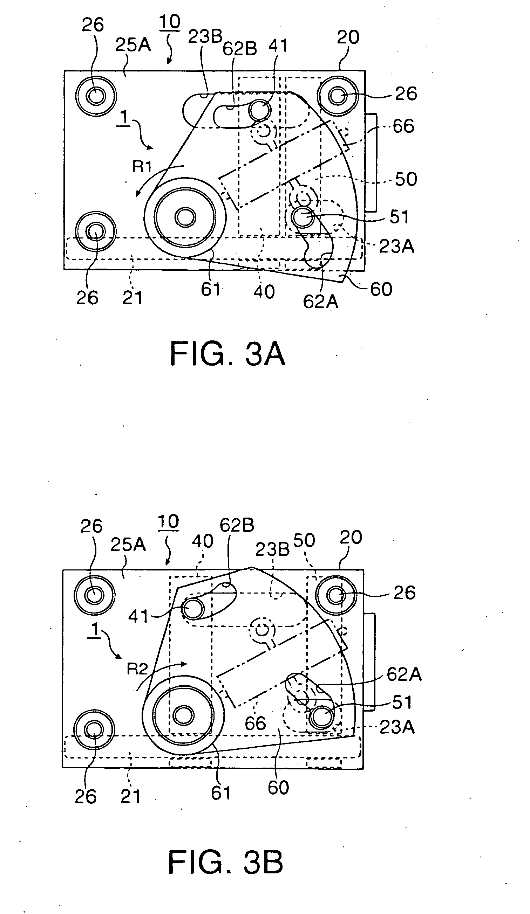

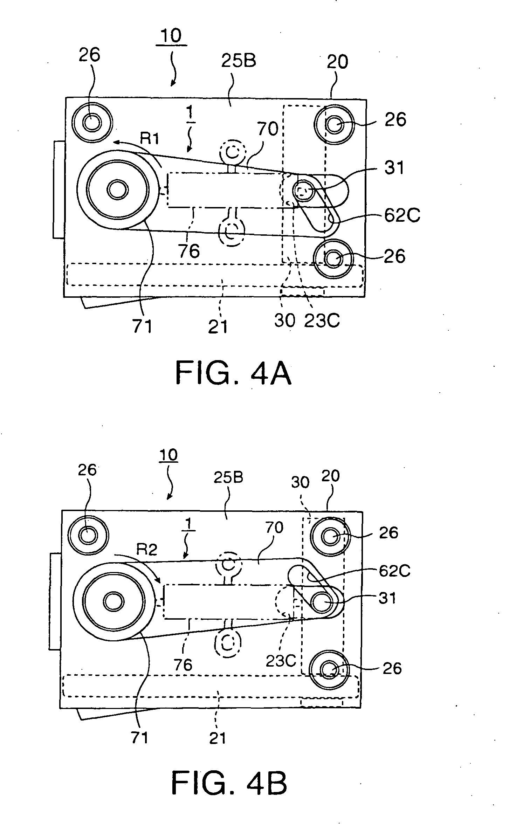

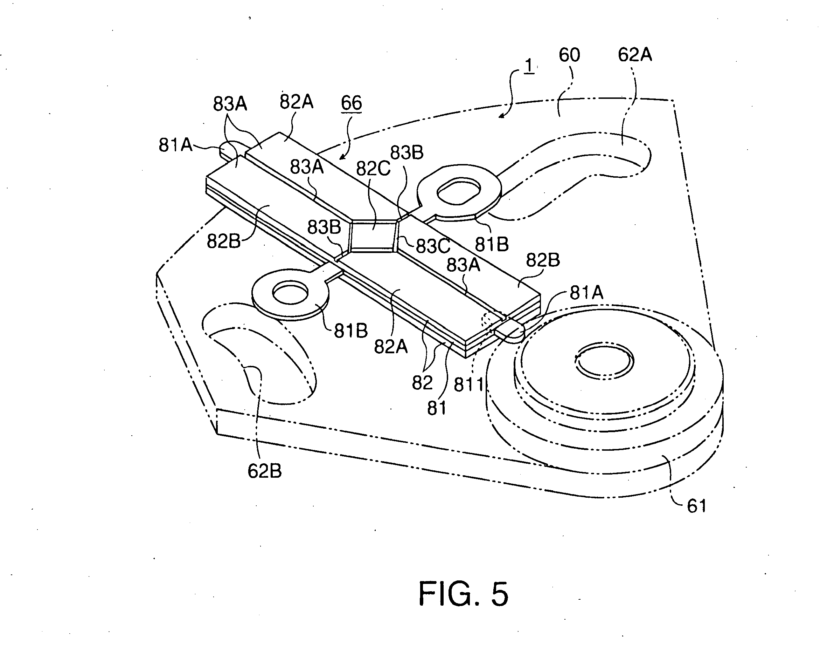

Fig. 1 is a perspective view of the lens unit 10 when seen from the upper right, and Fig. 2 is a perspective view of the lens unit 10 when seen from the upper left. FIGS. 3A and 3B are diagrams showing the operation of a cam member 60, and FIGS. 4A and 4B are diagrams showing the operation of a cam member 70. Fig. 5 is an enlarged perspective view of an oscillating member 66 that drives the cam member 60.

In FIGS. 1 to 5, the lens unit 10 includes a case 20, a first lens 30, a second lens 40, a third lens 50, a cam member 60, a cam member 70, an oscillating member 66, and an oscillating member 76. The case 20 has a substantially rectangular shape as a whole. The first lens 30, the second lens 40, and the third lens 50 are driven members. The cam member 60 drives the second lens 40 and the third lens 50 such that the lenses advance and retract. The cam member 70 drives the first lens 30 such that the first lens 30 advances and retracts. The oscillating member 66 is a piezoelectric actuator to rotatably drive the cam member 60. The oscillating member 76 is a piezoelectric actuator to rotatably drive the cam member 70. Among these members, the drive apparatus 1 that drives the lenses 30, 40, and 50 is configured by the cam members 60 and 70 and the oscillating members 66 and 76. The configurations are described in detail below.

In the case 20, two rod-shaped guiding shafts 21 are disposed to be parallel to each other from the front surface to the back surface. These guiding shafts 21 are members that guide the lenses 30, 40, and 50 to be driven so that they advance and retract. Further, the guiding shafts 21 pass through the lenses 30, 40, and 50 in the direction in which the lenses 30, 40, and 50 are advanced and retracted (optical axis direction). Also, the guiding shafts 21 perform a function of preventing the lenses 30, 40, and 50 from falling to the front or back of the case.
Elongated openings 23A, 23B, and 23C are provided in the side portions 22 at both sides of the case 20. Each of these openings 23A, 23B, and 23C is formed to have a size that allows the camshafts 31, 41, and 51 provided for the lenses 30, 40, and 50 to move sufficiently.

The first lens 30 is disposed in the case 20, and includes the camshaft 31 located in the opening 23C of the case 20. The second lens 40 is disposed in the case 20, and includes the camshaft 41 located in the opening 23B of the case 20. The third lens 50 is disposed in the case 20, and includes the camshaft 51 located in the opening 23A of the case 20.

In the first to third lenses 30, 40, and 50, central condensers 32 and 42, and a condenser of the third lens 50 (not shown) are integrally formed from a lens material together with enclosing frame mounting portions 33 and 43 and a frame mounting portion of the third lens 50 (not shown). The lenses also have holding frames 34, 44, and 54 to hold these elements. The above-described camshafts 31, 41, and 51 are provided in these holding frames 34, 44, and 54.

Further, the first lens 30 is a focus lens, and the second lens 40 and third lens 50 are zoom lenses. Further, the third lens 50 is not limited to a zoom lens, and may also be a focus lens. In this case, the lens unit 10 can be used as a unit for a focus lens by appropriately designing the configurations of the lenses 30, 40, and 50 and the optical characteristics of the lenses 30, 40, and 50.

Further, the second lens 40 is configured by combining a concave lens and a convex lens, but the structures and the like of each of the lenses 30, 40, and 50 may be arbitrarily determined in view of their intended use.
Furthermore, in the lenses 30, 40, and 50 according to the present embodiment, the condensers 32 and 42 and the condenser of the third lens 50 are preferably integrally formed from a lens material together with the frame mounting portions 33 and 43 and the frame mounting portion of the third lens 50. However, another possibility is to form only the condensers 32 and 42 and the condenser of the third lens 50 from a lens material, and to form the frame mounting portions 33 and 43 and the frame mounting portion of the third lens 50 integrally with the holding frames 34, 44, and 54 from another material. Further, the condensers 32 and 42, the condenser of the third lens 50, the frame mounting portions 33 and 43 and the frame mounting portion of the third lens 50, and the holding frames 34, 44, and 54 may all be configured from an integral lens material.

The cam members 60 and 70 are respectively disposed between outer surfaces 25A and 25B, which are located at both sides of the case 20, and cover members 10A, each of which is fixed on the outside of these outer surfaces 25A and 25B by three legs 26.

The cam member 60 has a substantially fan shape with a rotating shaft 61, and is supported on the outer surface 25A of the case 20 while being allowed to rotate about the rotating shaft 61. Also, two cam grooves 62A and 62B are formed as drive guide units in the flat portion of the cam member 60. These cam grooves 62A and 62B are formed in a substantially circular arc shape. The camshaft 41 of the second lens 40 engages with the cam groove 62B, and the camshaft 51 of the third lens 50 engages with the cam groove 62A. Therefore, when the cam member 60 is rotated, the camshafts 51 and 41 are led by the cam grooves 62A and 62B to move at a speed and within a movement range determined by the shapes of the cam grooves 62A and 62B. Thus, the third lens 50 and the second lens 40 are made to advance and retract.

The cam member 70 has a substantially lever shape with a rotating shaft 71, and is supported on the other outer surface 25B of the case 20 while being allowed to rotate about the rotating shaft 71. Further, one cam groove 62C is formed as a drive guide unit in a flat portion of the cam member 70. This cam groove 62C has a substantially circular arc shape, the camshaft 31 of the first lens 30 engages with the cam groove 62C. As a result, when the cam member 60 is rotated, the camshaft 31 is led by the cam groove 62C to move at a speed and within a movement range determined by the shape of the cam groove 62C. Thus, the first lens 30 is made to advance and to retract.

In these cam members 60 and 70, the oscillating members 66 and 76 that oscillate within a plane substantially perpendicular to the rotating shafts 61 and 71 come into contact with the outer peripheral surfaces of the rotating shafts 61 and 71. At this time, the direction in which the oscillating members 66 and 76 come into contact with the rotating shafts 61 and 71 is not particularly limited, and may be a direction in which the rotating shafts 61 and 71 can be rotated.
Further, openings may be provided in the flat portions of the cam members 60 and 70 so that the oscillating members 66 and 76 may be disposed inside these openings, and the oscillating members 66 and 76 may come into contact with the outer peripheral surfaces of the rotating shafts 61 and 71. In this case, the sizes of the openings should be sufficient for the cam members 60 and 70 to rotate without coming into contact with the oscillating members 66 and 76. In addition, the oscillating members 66 and 76 in this case may be supported either on the outer surfaces 25A and 25B of the case 20 or on the cover member 10A.
Further, in the outer peripheral surfaces of the rotating shafts 61 and 71, the contact portions of the oscillating members 66 and 76 in particular are formed without any irregularities in order to prevent abrasion. The outer diameters of the contact portions of the oscillating members 66 and 76 are preferably made relatively large to allow the lenses 30, 40, and 50 to be more accurately driven because of the reduced angle of rotation with respect to the oscillation frequency. The external radial shape of the rotating shafts 61 and 71 is preferably a circular arc shape in the contact portions alone. Further, the other surfaces need not particularly have a circular arc shape.

As seen in Fig. 5, the oscillating member 66 has a reinforcing plate 81 formed in a substantially rectangular flat plate shape, and piezoelectric elements 82 with a substantially rectangular flat plate shape provided on the front and back surfaces of the reinforcing plate 81.
The reinforcing plate 81 has preferably concave portions 811 formed near the center of the short side at both ends thereof in the longitudinal direction, and convex members 81A with a substantially elliptical shape are disposed on these concave portions 811. These convex members 81A are formed of any highly rigid materials, such as ceramic. Here, about half is disposed inside the concave portions 811 of the reinforcing plate 81, and the other half is disposed to protrude from the short side of the reinforcing plate 81. The front end of one of these convex members 81A comes into contact with the peripheral surface of the rotating contact shaft 61.
Arm units 81B are formed integrally to substantially the center of the reinforcing plate 81 in a longitudinal direction so as to protrude from both sides in the width direction. The arm units 81B protrude nearly at right angles from the reinforcing plate 81, and the ends thereof are fixed to the cover member 10A by screws (not shown). This reinforcing plate 81 is formed of stainless steel or other materials.

The piezoelectric elements 82 bonded to the substantially rectangular portions on both sides of the reinforcing plate 81 are formed of materials appropriately selected from among the following: lead zirconate titanate (PZT), quartz, lithium niobate, barium titanate, lead titanate, lead metaniobate, polyvinylidene fluoride, lead zinc niobate, lead scandium niobate, and the like.
Further, electrodes are formed on both surfaces of the piezoelectric elements 82 by forming a nickel plating layer and a gold plating later. These electrodes are designed such that a plurality of electrodes that are electrically insulated from each other by cut-out grooves are formed in linear symmetry about a center line that extends in the longitudinal direction. That is, at the center of the piezoelectric element 82 in a transverse direction, a groove 83A is formed along the longitudinal direction, and at the center of the piezoelectric element 82 in a longitudinal direction, a groove 83B is formed along the transverse direction. In addition, at substantially the center of the piezoelectric element 82, the groove 83C on which the four substantially rectangular corners are disposed on the grooves 83A and 83B is formed. On the surface of the piezoelectric element 82, five electrodes including the pairs of drive electrodes 82A and 82B, and the detection electrode 82C are formed by these grooves 83A, 83B, and 83C. In this case, the drive electrodes 82A and 82B are provided on both sides on the diagonal line and oscillate the oscillating member 66 to drive the rotating shaft 61, and the detection electrode 82C is formed in a substantially rectangular shape (substantially rhombus shape) at the center of the piezoelectric element 82, and detects the oscillation behavior of the oscillating member 66.

In the present embodiment, the piezoelectric elements 82 are formed into rectangular shapes with a short side of about 1 mm and a long side of about 3.5 mm. Also, the surface area of the detection electrode 82C is are set to 1/30th or more and 1/7th or less, and preferably the surface areas are set to 1/15th or more and 1/10th or less, of the total of the surface areas of the drive electrodes 82A and 82B, that is, the total of the surface areas of the pair of drive electrodes 82A or the total of the surface areas of the pair of drive electrodes 82B. In this case, the area of the detection electrode 82C is preferably small, because the strain of the oscillation in an oscillation mode other than a desired oscillation mode can be removed. However, if the area of the detection electrode 82C is smaller than 1/30 of the area of the drive electrode 82A or the drive electrode 82B, the detection signal becomes weak, and an excellent detection signal cannot be extracted. Further, if the area of the detection electrode 82C is large, the detection signal becomes strong. However, if the area of the detection electrode 82C is larger than 1/7 of the area of the drive electrode 82A or the drive electrode 82B, a strain component of the oscillation in an oscillation mode other than the desired oscillation mode increases, and thus the strain component of the oscillation may be detected. Therefore, a predetermined detection signal cannot be obtained.

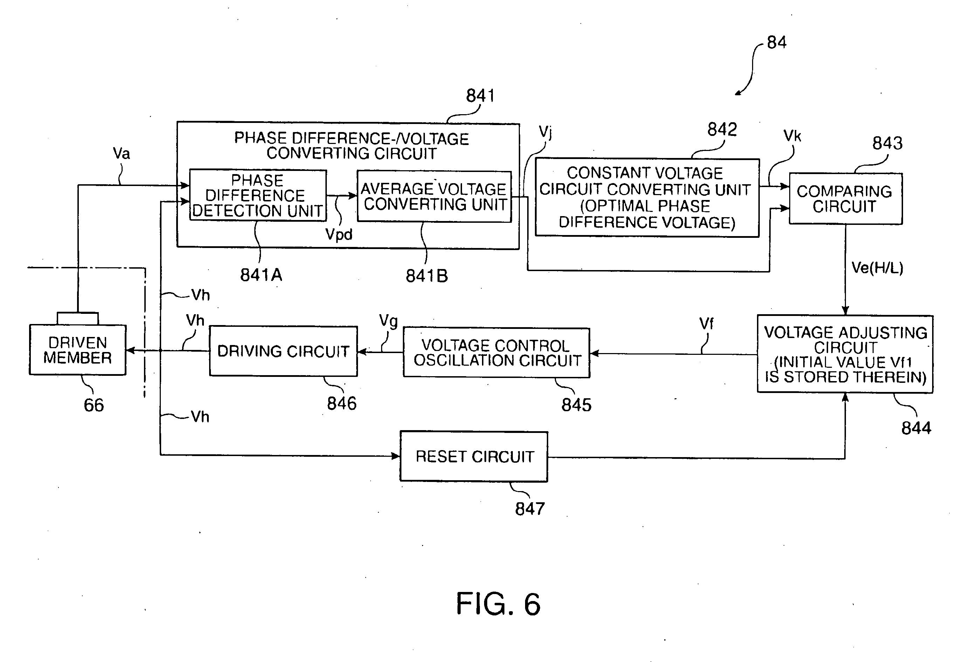

Further, since the oscillating member 66 according to the present embodiment is very small, it is difficult to form a plurality of electrodes by forming grooves. However, in the piezoelectric element 82, the other portion excluding the detection electrode 82C is divided into four portions, which achieves shapes of the drive electrodes 82A and 82B that excite oscillation in a longitudinal primary oscillation mode and a flexural secondary oscillation mode with grooves of the small number.
The pair of drive electrodes 82A and the pair of drive electrodes 82B are connected to each other by leading lines (not shown), and these leading lines are connected to a voltage applying device 84 (see Fig. 6), which serves as a control device that controls the oscillation behavior of the oscillating member 66. Also, the detection electrode 82C is connected to the voltage applying device 84 by a leading line (not shown), and the reinforcing plate 81 is connected to a ground by a leading line (not shown).
These electrodes 82A, 82B, and 82C are provided in the same manner as in the piezoelectric elements 82 on the front and rear sides with the reinforcing plate 81 interposed therebetween, and for example, the electrode 82A is formed on the back surface side of the electrode 82A.

The piezoelectric elements 82 that have the above-described structure can excite the oscillating member 66 between oscillation of a longitudinal primary oscillation mode as a longitudinal oscillation mode, in which the piezoelectric element expands and contracts along the longitudinal direction of the oscillating member 66, and oscillation of a flexural secondary oscillation mode as a flexural oscillation mode that creates flexural oscillation in the width direction (transverse direction) of the oscillating member 66, that is, creates flexural oscillation in the direction substantially perpendicular to the oscillation direction of the longitudinal primary oscillation mode by selecting a predetermined electrode from the drive electrodes 82A and 82B on the front surface and applying a voltage from the voltage applying device 84. That is, when, for example, a voltage is applied only to the drive electrode 82A, oscillation in the longitudinal primary oscillation mode is induced as a result of the fact that the portion of the piezoelectric element 82 on which the drive electrode 82A is formed expands and contracts in a direction within a plate-shaped surface. At this time, since the voltage is not applied to the drive electrode 82B, the oscillation in the longitudinal primary oscillating mode is obstructed in the corresponding portion, and the overall oscillating behavior of the oscillating member 66 becomes unbalanced along the central line in the longitudinal direction. Therefore, the oscillating member 66 excites the oscillation in the flexural secondary oscillation mode creating flexural oscillation in a direction substantially perpendicular to the longitudinal direction of the oscillating member 66. As a result, the convex members 81A of the oscillating member 66 oscillate while describing a substantially elliptical path that combines the oscillation of the longitudinal primary oscillation mode and the oscillation of the flexural secondary oscillation mode. In a part of this substantially elliptical path, the convex members 81A rotate the rotating shaft 61 in the direction of the tangent line.
Accordingly, at the time, the detection electrodes 82C are formed at positions where the strain due to the oscillation in the longitudinal primary oscillation mode becomes maximized at the node of the oscillation in the longitudinal primary oscillation mode, and the strain due to the oscillation in the flexural secondary oscillation mode becomes minimized at the node of the oscillation in the flexural secondary oscillation mode.

Further, the rotational direction of the rotating shaft 61 can be set to forward rotation or reverse rotation when the oscillating member 66 is oscillated by appropriately switching the electrode through which the voltage is applied to the piezoelectric elements 82.
For example, if the rotational direction when the voltage is applied to the drive electrodes 82A is set to forward rotation, the direction of oscillation in the flexural secondary oscillation mode is reversed when the voltage is applied to the electrodes 82B, and the rotational direction of the rotating shaft 61 is reversed.
In this case, the drive frequency of the drive voltage (drive signal) applied to the piezoelectric elements 82 is set to a level at which the resonance point of oscillation in the flexural secondary oscillation mode also occurs near the resonance point of oscillation in the longitudinal primary oscillation mode when the oscillating member 66 oscillates, and the convex members 81A describes an appropriate substantially elliptical path.
Furthermore, strain is induced by the oscillation of the entire oscillating member 66 in the piezoelectric elements 82 in the portions in which the detection electrodes 82C are formed, and a detection signal corresponding to the oscillation of the oscillating member 66 is therefore detected from the detection electrodes 82C due to this strain.

The dimensions, thickness, material, and aspect ratio of the piezoelectric elements 82, the divided type of the electrodes, and the like are appropriately determined so that the convex members 81A can easily move in an appropriate and substantially elliptical path when a voltage is applied to the piezoelectric elements 82.
Further, the waveform of the alternating current voltage applied to the oscillating member 66 is not particularly limited, and, for example, a sine wave, a rectangular wave, a trapezoidal wave, or the like can be employed.
Further, the oscillating member 76 has the same structure as the oscillating member 66, and a description of which is herein omitted because it can be understood from the description of the oscillating member 66.

Fig. 6 is a block diagram showing a structure of the voltage applying device 84. In Fig. 6, the voltage applying device 84 includes a phase difference/voltage converting circuit 841, a constant voltage circuit 842, a comparing circuit 843, a voltage adjusting circuit 844, a voltage control oscillation circuit 845, a driver circuit 846, and a reset circuit 847.
The phase difference/voltage converting circuit 841 detects the phase difference between the phase of a detection signal Va detected from the detection electrodes 82C, and the phase of a drive signal Vh applied to the drive electrode 82A or the drive electrode 82B, and outputs to the comparing circuit 843, a phase difference voltage signal Vj whose voltage value corresponds to the average phase difference.

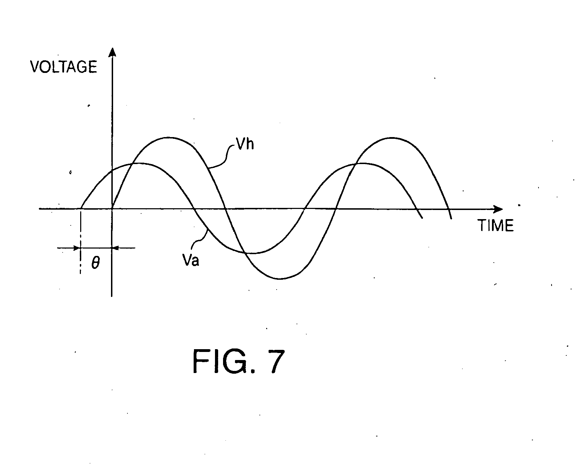

Fig. 7 is a diagram showing the phase difference θ between the drive signal Vh and the detection signal Va. As shown in Fig. 7, the phase difference θ is detected as the positive (+) when it is not synchronous with the direction in which the detection signal Va progresses with the drive signal Vh as a reference.
The phase difference/voltage converting circuit 841 includes a phase difference detecting unit 841A and an average voltage converting unit 841B. When the detection signal Va and the drive signal Vh are inputted, the phase difference detecting unit 841A generates a phase difference signal Vpd whose pulse width is equivalent to the phase difference of both signals, and outputs this signal to the average voltage converting unit 841B. The average voltage converting unit 841B generates a phase difference voltage signal Vj whose average voltage value is equivalent to the pulse width of the phase difference signal Vpd by means of an integrating circuit (not shown), and outputs this signal to the comparing circuit 843.

The constant voltage circuit 842 outputs the calculated predetermined reference phase difference signal Vk whose voltage value is equivalent to the optimum phase difference (the target phase difference) between the phase of the detection signal Va and the phase of the drive signal Vh, to the comparing circuit 843.
Here, the reference phase difference signal Vk is preferably set to a phase difference that corresponds to the drive frequency at which the oscillating member 66 oscillates with maximum efficiency and at which the oscillation component ratio between the longitudinal primary oscillation mode and the flexural secondary oscillation mode is optimal.

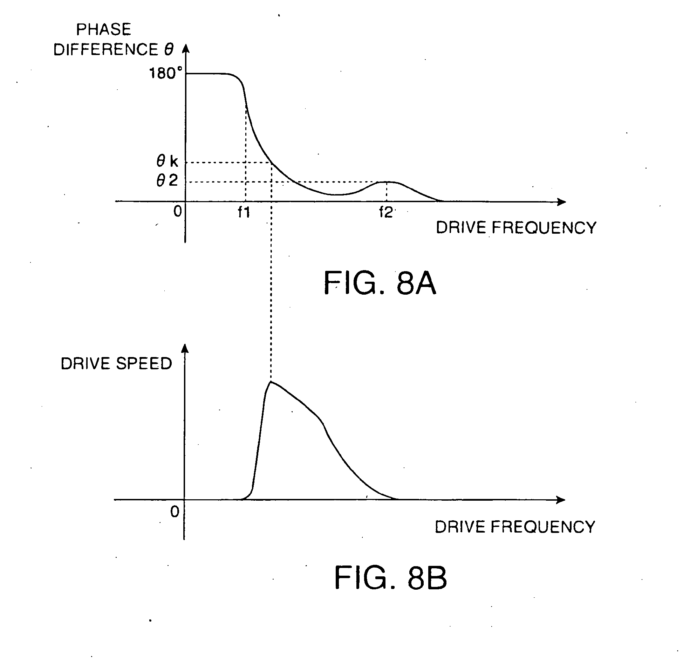

Fig. 8 shows the behavior characteristics of the oscillating member 66 with respect to the drive frequency. Fig. 8(A) shows the relationship between the drive frequency and the phase difference θ. Fig. 8(B) shows the relationship between the drive frequency and the drive (rotating) speed of the rotating shaft 61. As shown in Fig. 8(A), it is clear that when the drive frequency of the oscillating member 66 varies, the phase difference θ has a large value near the resonance frequency f1 of the oscillation in the longitudinal primary oscillation mode and near the resonance frequency f2 of the oscillation in the flexural secondary oscillation mode. Further, as shown in Fig. 8(B), it is clear that when the drive frequency of the oscillating member 66 is varied, the drive speed of the rotating shaft 61 increases between the resonance frequency f1 of the oscillation in the longitudinal primary oscillation mode and the resonance frequency f2 of the oscillation in the flexural secondary oscillation mode, and in particular, reaches a maximum at the drive frequency near the resonance frequency f1 of the oscillation in the longitudinal primary oscillation mode. This is because the oscillation of the general longitudinal primary oscillation mode ensures the drive torque of the oscillating member 66 more easily than does the oscillation in the flexural secondary oscillation mode. Accordingly, it is preferable to set the drive frequency to a frequency near the resonance frequency f1 of the oscillation in the longitudinal primary oscillation mode between the resonance frequency f1 of the oscillation in the longitudinal primary oscillation mode and the resonance frequency f2 of the oscillation in the flexural secondary oscillation mode.
Therefore, in the present embodiment, the frequency at which the drive speed of the rotating shaft 61 reaches a maximum is selected as the drive frequency, and the reference phase difference signal Vk is set to a level whose voltage value corresponds to the phase difference (the target phase difference) θk at this frequency.

In this case, since the detection electrodes 82C are formed at locations including the location where strain due to oscillation of the flexural secondary oscillation mode reaches a minimum, it is difficult for the detection signal to be affected by the oscillation in the flexural secondary oscillation mode. Accordingly, in the detection signal detected by the detection electrode 82C, a phase difference θ increases near the resonance frequency f1 of the oscillation in the longitudinal primary oscillation mode and the resonance frequency f2 of the oscillation in the flexural secondary oscillation mode. However, it can be understood that the variation of the phase difference θ due to the oscillation in the flexural secondary oscillation mode becomes smaller than the variation of the phase difference θ due to the oscillation in the longitudinal primary oscillation mode. In addition, as can be understood from Fig. 8(A), since the phase difference θk is larger than the phase difference θ2 in the resonance frequency f2 of the oscillation in the flexural secondary oscillation mode, the drive frequency corresponding to the phase difference θk is always determined to a single value.
That is, since the detection electrodes 82C are formed at locations where the phase difference θ due to the oscillation mode (the flexural secondary oscillation mode) other than the mainly used oscillation mode (the longitudinal primary oscillation mode) is less than the target phase difference θk, the phase difference θ only reaches the target phase difference. Accordingly, since the drive signal with respect to the target phase difference θk is determined to the single value, the applying device 84 controls the drive signal on the phase difference so as to optimally adjust the drive signal.

The comparing circuit 843 receives the phase difference voltage signal Vj from the phase difference/voltage converting circuit 841 and the reference phase difference signal Vk from the constant voltage circuit 842 and compares these signals. That is, when the condition "a phase difference voltage signal Vj ≥ a reference phase difference signal Vk" is satisfied, the comparing circuit 843 outputs an "H" level comparison result signal Ve to the voltage adjusting circuit 844, and when the condition "a phase difference voltage signal Vj < a reference phase difference signal Vk" is satisfied, the comparing circuit 843 outputs an "L" level comparison result signal Ve to the voltage adjusting circuit 844.
The voltage adjusting circuit 844 receives the comparison result signal Ve from the comparing circuit 843, and varies the voltage value of the adjustment signal Vf outputted to the voltage control oscillation circuit 845 in units of a predetermined voltage value Vf0. Specifically, when the "H" level comparison result signal Ve is inputted, the voltage adjusting circuit 844 increases the voltage value of the adjustment signal Vf by a predetermined voltage value Vf0, and when the "L" level comparison result signal Ve is inputted, the voltage adjusting circuit 844 reduces the voltage value of the adjustment signal Vf by a predetermined voltage value Vf0. Further, an initial value Vf1, which is the initial adjustment signal, is stored in the voltage adjusting circuit 844, and when the voltage applying device 84 is started, the adjustment signal Vf whose voltage value is the initial value Vf1 is outputted to the voltage control oscillation circuit 845. Further, the initial value Vf1 is the upper limit of the adjustment range of a preset drive frequency, and in the present embodiment, the adjustment range of the drive frequency is set in a range ranging from a frequency lower than the resonance frequency f1 of the oscillation in the longitudinal primary oscillation mode by a predetermined value to a frequency higher than the resonance frequency f2 of the oscillation in the flexural secondary oscillation mode by a predetermined value. In this case, the initial value Vf1 is set to a frequency higher than the resonance frequency f2 of the oscillation in the flexural secondary oscillation mode by a predetermined value.

The voltage control oscillation circuit 845 inputs the adjustment signal Vf from the voltage adjusting circuit 844 and adjusts the frequency of the reference signal Vg outputting to the driver circuit 846. Specifically, when the voltage value of the adjustment signal Vf is higher than the voltage value of the previous adjustment signal Vf, the voltage control oscillation circuit 845 increases the frequency of the reference signal Vg by a predetermined value f0, and when the voltage value of the adjustment signal Vf is lower than the voltage value of the previous adjustment signal Vf, the voltage control oscillation circuit 845 decreases the frequency of the reference signal Vg by a predetermined value f0. Also, in a case in which the adjustment signal Vf with the initial value Vf1 is inputted when the voltage applying device 84 is started, the voltage control oscillation circuit 845 outputs a reference signal Vg with a preset frequency.
The driver circuit 846 receives the reference signal Vg from the voltage control oscillation circuit 845, and outputs the drive signal Vh that has a constant voltage value at the frequency of this reference signal Vg to the drive electrode 82A or the drive electrode 82B of the oscillating member 66.

When the frequency of the drive signal Vh from the driver circuit 846 is equal to or less than a predetermined value, the reset circuit 847 outputs to the voltage adjusting circuit 844 a reset signal that changes the frequency of the reference signal Vg to the frequency of the initial value Vf1. In this case, the predetermined value of the frequency at which the reset signal is outputted is set to the lower limit of the adjustment range of the drive frequency, and is set to a frequency lower than the resonance oscillation frequency f1 of the oscillation in the longitudinal primary oscillation mode in the present embodiment by a predetermined value. The voltage adjusting circuit 844 outputs the adjustment signal Vf whose voltage value is the initial value Vf1 to the voltage control oscillation circuit 845 when the reset signal is inputted from the reset circuit 847. The voltage control oscillation circuit 845 adjusts a frequency of the reference signal Vg on the basis of the adjustment signal Vf.

Therefore, first, when the voltage applying device 84 is driven, it applies the drive signal Vh to the oscillating member 66 on the basis of the reference signal Vg of a frequency corresponding to the voltage value of the initial value Vf1. At this time, since the initial value Vf1 is set to the upper limit of the adjustment range of the drive frequency, the phase difference voltage signal Vj that results from the phase difference θ between the drive signal Vh and the detection signal Va at the normal initial level becomes weaker than the reference phase difference signal Vk from the constant voltage circuit 842. Therefore, an "L" level comparison result signal Ve is outputted by the comparing circuit 843, and the voltage adjusting circuit 844 lowers the voltage value of the adjustment signal Vf by a predetermined voltage value Vf0 on the basis of this comparison result signal Ve, such that the frequency of the reference signal Vg from the voltage control oscillation circuit 845 is lowered by a predetermined value f0.
As a result of repeating this operation, the frequency of the drive signal Vh applied to the oscillating member 66 is reduced, and when the condition "a phase difference voltage signal Vj ≥ a reference phase difference signal Vk" is satisfied, since the frequency of the drive signal Vh conversely increases, the result of which is that the phase difference voltage signal Vj corresponding to the phase difference θ between the drive signal Vh and the detection signal Va is controlled and held near the reference phase difference signal Vk.
Further, when the frequency of the drive signal Vh decreases and falls below the predetermined value of the reset circuit 847 as a result of any factor, the adjustment signal Vf of the voltage adjusting circuit 844 is reset to a value corresponding to the initial value Vf1, and the drive frequency is again controlled from the upper limit of the adjustment range of the drive frequency.
Further, as for the oscillating member 76, a voltage applying device (not shown) having the same structure is provided, and as for the control of the oscillation of the oscillation member 76, the control is performed in the same manner as the oscillating member 66.

Next, the operation of the lens unit 10 will be described with reference to Fig. 3.
First, when the oscillating member 66 in contact with the outer periphery of the rotating shaft 61 oscillates, the rotating shaft 61 rotates at a predetermined angle. The cam member 60 integrated with the rotating shaft 61 also rotates at a predetermined angle due to this rotation, and as a result, the cam grooves 62A and 62B formed in the cam member 60 also rotate. Thus, the outer peripheral surfaces of the camshafts 51 and 41 fitted into the cam grooves 62A and 62B move within the openings 23A and 23B while being guided by the inner peripheral surfaces of the cam grooves 62A and 62B.
For example, when the rotating shaft 61 is rotated from the position of Fig. 3A in the counterclockwise direction (R1), the second lens 40 and the third lens 50 that have the camshafts 41 and 51 move away from each other, and the interval between the second lens 40 and the third lens 50 widens, as shown in Fig. 3B.
In contrast, when the drive electrodes 82A and the drive electrodes 82B to which the voltage is applied are switched and the rotating shaft 61 is rotated from the position of Fig. 3B in the clockwise direction (R2), the second lens 40 and the third lens 50 move in a direction adjacent to each other and return to their original positions of Fig. 3A.
In this way, the second lens 40 and the third lens 50 can function as zoom lenses.

Similarly in Fig. 4A and 4B, when the oscillating member 76 in contact with the outer periphery of the rotating shaft 71 oscillates, the rotating shaft 71 rotates at a predetermined angle. The cam member 70 integrated with the rotating shaft 71 also rotates at a predetermined angle due to this rotation. The cam groove 62C formed in the cam member 70 also rotates, and the outer peripheral surface of the camshaft 31 fitted in the cam groove 62C move within the openings 23C while being guided by the inner peripheral surface of the cam groove 62C.
For example, when the rotating shaft 71 is rotated from the position of Fig. 4A in the counterclockwise direction (R1), the first lens 30 connected to the camshaft 51 moves outward from the center direction of the case 20 and draws toward the end of the case 20, as shown in Fig. 4B.
In contrast, when the rotating shaft 71 is rotated in the clockwise direction (R2) from the position of Fig. 4B, the first lens 30 moves to the center of the case 20 and returns to its original position of Fig. 4A.
In this way, the first lens 30 can function as a focus lens.

As described above, direct oscillation is applied to the rotating shafts 61 and 71 of the cam members 60 and 70 while appropriately switching the drive electrodes 82A and the drive electrodes 82B with the voltage applied to the piezoelectric elements 82. Thus, the first lens 30, the second lens 40, and the third lens 50 are driven to advance and retract as shown in Figs. 3A, 3B, 4A, and 4B.
At this time, the positions of the lenses 30, 40, and 50 are read by a reading sensor (not shown), and are fed back to the control circuit for drive control, so that the lenses 30, 40, and 50 can be stopped at suitable positions.

According to the first embodiment described above, the following effects are obtained.
(1) The detection electrodes 82C are provided at the substantially center of the piezoelectric element 82, and at locations including the locations where the strain due to the oscillation of the flexural secondary oscillation mode becomes minimized, that is, at positions including an oscillation node of the flexural secondary oscillation mode. As a result, it is possible to suppress the influence on the detection signal Va due to the oscillation of the flexural secondary oscillation mode to the minimum. Therefore, as shown in Fig. 8(A) and 8(B), the phase difference θ between the drive signal Vh and the detection signal Va can be reduced near a resonance frequency f2 of the oscillation of the flexural secondary oscillation mode. Therefore, since the phase difference (the target phase difference) θk corresponding to the drive frequency at which the drive speeds of the rotating shafts 61 and 71 are maximized becomes larger than the phase difference 02 in the resonance frequency f2 of the oscillation in the flexural secondary oscillation mode, it is possible to determined to a single value one drive signal Vh (drive frequency) with respect to the reference phase difference signal Vk that has a voltage value corresponding to the phase difference θk.

Meanwhile, in a piezoelectric actuator according to the related art as shown in Fig. 31, the drive frequency corresponding to the phase difference is not determined to a single value, and it is therefore impossible to constantly control the frequency of the drive signal Vh in an optimal manner.
As described above, since the frequency of the drive signal Vh can be always determined to a single value by approximately setting the location of the detection electrode 82C, the oscillation control of the oscillating members 66 and 76 can be surely performed. Further, since the optimal drive speed can be ensured, the drive efficiency of the drive device 1 can be improved.
At this time, the detection electrodes 82C are formed at the locations including the oscillation node in the longitudinal primary oscillation mode. At the node location, since the amplitude of the oscillation of the longitudinal primary oscillation mode becomes maximized, it is possible to easily detect the oscillation in the longitudinal primary oscillation mode.

(2) The surface areas of the detection electrodes 82C are set to 1/30th or more and 1/7th or less, and more preferably to 1/15th or more and 1/10th or less, of the total of the surface areas of the drive electrodes 82A and 82B. Therefore, oscillation can be reliably detected by the detection electrodes 82C, and the drive force necessary to drive the rotating shafts 61 and 71 can be ensured by maintaining the desired total surface areas of the drive electrodes 82A and 82B. Further, since the surface areas of the detection electrodes 82C are appropriately set, it is possible to suppress an influence on the phase difference due to the oscillation in the flexural secondary oscillation mode. Therefore, it is possible to accurately detect the detection signal.

(3) Since the detection electrodes 82C are provided at substantially the center of the oscillating members 66 and 76 so as to be separated from the drive electrodes 82A and 82B, the oscillation can be detected regardless of the oscillation direction of the oscillating members 66 and 76 (oscillation direction in the flexural secondary oscillation mode). For example, in a case where the electrodes among the drive electrodes, which are not used, are also used as the detection electrodes, if the drive electrode is switched so as to switch the oscillation direction, the detection electrode needs to be switched, which complicates the wiring line or the control operation. In the present embodiment, since the detection electrode 82C is provided to be separated from the drive electrodes 82A and 82B, the structure of the voltage applying device 84 can be simplified.

(4) Since the phase difference θ between the drive signal Vh and the detection signal Va is used as the object of control for the drive signal Vh, the variation of the object of control is limited to a range of 0 to 180°. That is, even when the voltage of the drive signal is changed, the controlled phase difference θ is in a range of 0 to 180°. Therefore, if the voltage applying device 84 is formed of a control circuit that can be control the phase difference in a range of the phase difference, the common control circuit can be used even when the voltage of the drive signal is changed. Therefore, the versatility of the control circuit can be improved. Meanwhile, when the voltage or the current of the drive signal is used as the control object of the drive signal Vh, the voltage value or the current value of the detection signal is much changed. As a result, another control circuit needs to be prepared in which withstand pressure is changed according to the variation, and the common control circuit cannot be used. Accordingly, in the voltage applying device 84 according to the present embodiment, the phase difference θ between the drive signal Vh and the detection signal Va is used as the control object. Therefore, it is possible to cope with the different voltage setting without drastically changing the reference phase difference signal Vk in the common circuit, and the drive signal Vh can be surely suppressed.

(5) Since the oscillating members 66 and 76 are formed in a flat shape, the small-sized drive device 1 can be achieved, and thus the small-sized lens unit 10 can be achieved. Further, since the convex member 81A comes into contact with the rotating shafts 61 and 71, the rotating angles of the rotating shafts 61 and 71 can be maintained by means of the friction between the convex member 81A and the outer peripheries of the rotating shafts 61 and 71, when the oscillation of the oscillating members 66 and 67 is stopped.

### [Second Embodiment]

Next, a second embodiment of the present invention will be described. In the second embodiment, the piezoelectric actuator according to the present invention is applied to a timepiece as an apparatus.

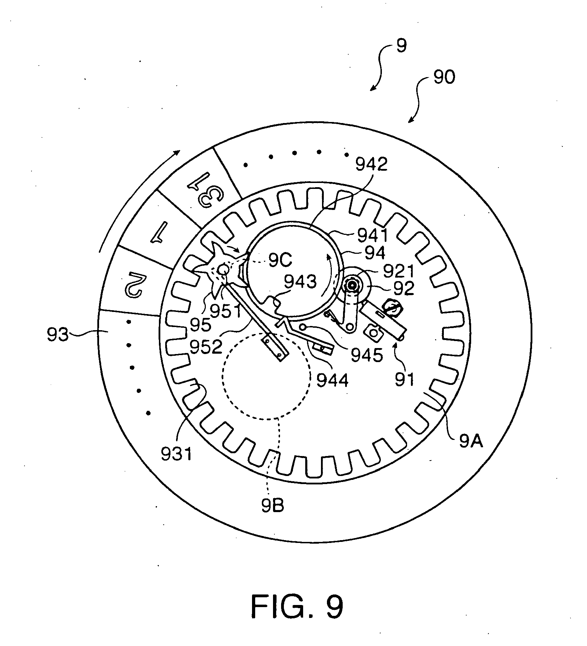

Fig. 9 is a plan view showing a date display mechanism 90 of a timepiece 9 according to the second embodiment of the present invention. In Fig. 9, the main section of the date display mechanism 90 is essentially configured from a piezoelectric actuator 91, a rotor 92 that is a driven member rotatably driven by the piezoelectric actuator 91, a reduction gear train to transmit the rotation of the rotor 92 while decelerating it, and a date wheel 93 that rotates by the drive force transmitted through the reduction gear train. The reduction gear train includes a date turning intermediate wheel 94 and a date turning wheel 95. The piezoelectric actuator 91, the rotor 92, the date turning intermediate wheel 94, and the date turning wheel 95 are supported on a bottom plate 9A.

A disc-shaped dial (not shown) is provided on the top of the date display mechanism 90, and a part of the outer peripheral surface of the dial is provided with a window to display the date, and is designed so that the date on the date wheel 93 is visible through the window. Further, a pointer movement gear train (not shown) connected to the stepping motor to drive the pointers, and a secondary battery 9B as a power source are provided on the bottom (reverse side) of the bottom plate 9A. The secondary battery 9B supplies power to the circuits of the stepping motor, the piezoelectric actuator 91, and a voltage applying device (not shown). The structure may also be such that a power generator that generates power by utilizing solar power or the rotation of an oscillating weight is connected to the secondary battery 9B, and the power generated by this power generator is charged into the secondary battery 9B. Further, the power source is not limited to a secondary battery 9B that is charged by a power generator, and may be a common primary battery (for example, a lithium ion battery).

The date turning intermediate wheel 94 includes a large diameter portion 941 and a small diameter portion 942. The small diameter portion 942 has a cylindrical shape slightly smaller than the large diameter portion 941, and a notch 943 with a substantially square shape is formed in the outer peripheral surface thereof. The small diameter portion 942 is fixed to the large diameter portion 941 so as to form concentricity. A gear 921 at the top of the rotor 92 engages with the large diameter portion 941. Therefore, the date turning intermediate wheel 94 including the large diameter portion 941 and small diameter portion 942 rotates in conjunction with the rotation of the rotor 92.
A plate spring 944 is provided on the bottom plate 9A on the side of the date turning intermediate wheel 94. The base end of the plate spring 944 is fixed on the bottom plate 9A, and the front end is bent into a substantially V shape. The front end of the plate spring 944 is provided to be capable of going in and out of the notch 943 of the date turning intermediate wheel 94. A contact element 945 is disposed at a position near the plate spring 944, and this contact element 945 is designed to come into contact with the plate spring 944 when the date turning intermediate wheel 94 rotates and the front end of the plate spring 944 goes into the notch 943. In addition, a predetermined voltage is applied to the plate spring 944, and when the plate spring 944 comes into contact with the contact element 945, this voltage is applied to the contact element 945 as well. Therefore, the state in which the date wheel is turned can be detected by detecting the voltage of the contact element 945, and the amount by which the date wheel 93 rotates in one day can be detected.
The detection of the amount by which the date wheel 93 rotates is not limited to using the plate spring 944 or the contact element 945. It is possible to use devices in which the rotating state of the rotor 92 or the date turning intermediate wheel 94 is detected and a predetermined pulse signal is outputted. Specifically, it is possible to use various known rotation encoders, such as a photoreflector, a photointerrupter, an MR sensor, or the like.

The date wheel 93 has a ring shape, and an inner gear 931 is formed on the inner peripheral surface thereof. The date turning wheel 95 has a gear with preferably five teeth and engages with the inner gear 931 of the date wheel 93. Also, a shaft 951 is provided in the center of the date turning wheel 95. This shaft 951 is inserted into a through-hole 9C formed in the bottom plate 9A. The through-hole 9C is formed to extend along the peripheral direction of the date wheel 93. In addition, the date turning wheel 95 and the shaft 951 are urged upward and to the right in Fig. 9 by a plate spring 952 fixed on the bottom plate 9A. The date wheel 93 is also prevented from rocking by the urging action of the plate spring 952.

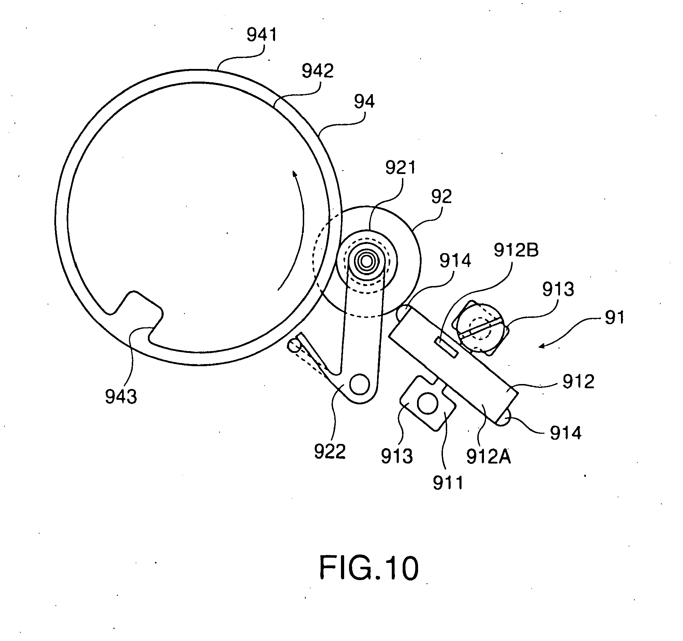

Fig. 10 is an enlarged view of the piezoelectric actuator 91 and the rotor 92. As shown in Fig. 10, the piezoelectric actuator 91 has a substantially rectangular reinforcing plate 911, and a piezoelectric element 912 bonded to both sides of the reinforcing plate 911.
Arm sections 913 that protrude from both sides of the reinforcing plate 911 are formed near the center of the reinforcing plate 911 in the longitudinal direction. One of these arm sections 913 is fixed on the bottom plate 9A by screws or the like. The other arm section 913 is not fixed to the bottom plate 9A, but remains in a free state, and constitutes a weight that takes oscillation balance when the piezoelectric actuator 91 oscillates.
Substantially hemispherical convex portions 914 that protrude along the longitudinal direction of the reinforcing plate 911 are formed at both ends of the diagonal of the reinforcing plate 911. One of these convex portions 914 comes into contact with the side of the rotor 92.

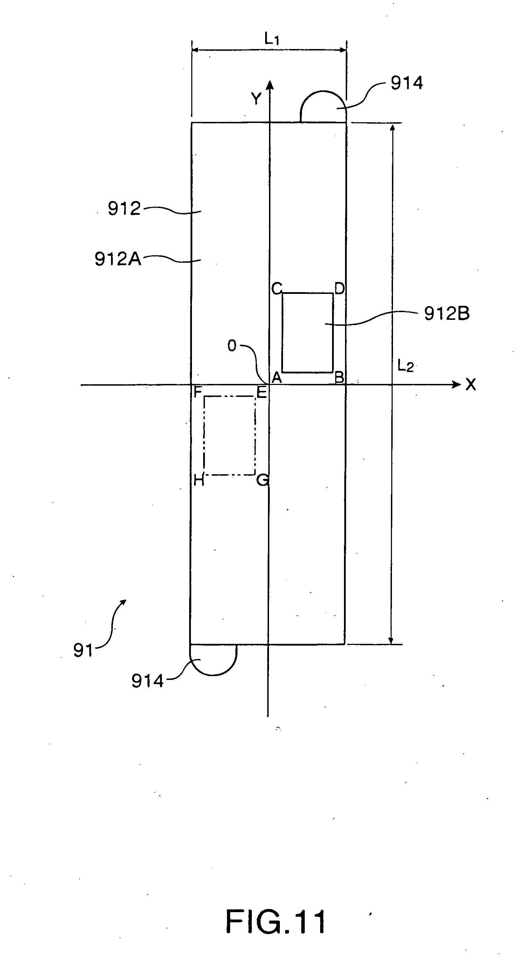

The piezoelectric element 912 is formed in a substantially rectangular shape, and is bonded to the substantially rectangular sections on both sides of the reinforcing plate 911. Electrodes are formed from a plating layer on both sides of the piezoelectric element 912, similar to the first embodiment. A substantially rectangular detection electrode 912B is formed in the surface of the piezoelectric element 912 by insulating the plating layer with a groove. This detection electrode 912B is formed nearer to the rotor 92 than to the longitudinal center of the piezoelectric element 912, and nearer to the convex portions 914 than the transverse center of the piezoelectric element 912, as shown in Fig. 11.

That is, in the second embodiment, the convex portions 914 on the diagonal of the reinforcing plate 911 are formed, and unbalance is caused by the projections of the element (the convex portion 914) to thereby excite another oscillation of the flexural secondary oscillation mode. When there is no unbalance state, locations where electric charge is offset by expansion and contraction respectively on the Y axis (the center axis of the longitudinal direction of the piezoelectric element 912) exist, but when there is unbalance state according to the embodiment, the convex portions 914 moves to some direction. Accordingly, in the embodiment, the detection electrode 912B is formed on X axis moved in the forward direction from Y axis, not on Y axis.

Fore example, when length of the transverse direction of the piezoelectric element 912 (shorter direction) is L₁ and length of the longitudinal direction is L₂, and then X and Y axes are set on the center of the transverse direction and the longitudinal direction respectively, the detection electrode 912B is formed in the area ABCD that exists in the forward direction (the right side of Fig. 11) of the intersection O between X and Y axes and in the forward direction (upward side of Fig. 11) of Y axis. In this case, locations of the points of the ABCD are determined in accordance with length ratio of L₁ and L₂, weight unbalance, etc, such as an example: A(X, Y)=(0.12L₁, 0.02L₂), B(X, Y)=(0.45L₁,0.02L₂), C(X, Y)=(0.12L₁, 0.25L₂), D(X, Y)=(0,45L₁, 0.25L₂).

Since the operation of the expansion and contraction by the piezoelectric element 912 has symmetry about the interaction O between X and Y axes, the detection electrode 912B may also be formed in the area EGFH shown in dotted line. For example, the detection electrode 912B may be formed at locations where electric charge is offset each other by the expansion and contraction due to the flexural secondary oscillation mode such as an example: E(X, Y)=(-0.12L₁, -0.02L₂) , F(X, Y)=(-0.45L₁, - 0.02L₂), G(X, Y)=(-0.12L₁, -0.25L₂), H(X, Y)=(-0.45L₁, - 0.25L₂).
The detection electrode 912B is formed in the other part except the detection electrode 912B. In this case, an area of the detection electrode 912B is set to be one thirtieth or more and one seventh or less the time of the area of the drive electrode 912A, and preferably one fifteenth or more and one tenth or less the time.

If the voltage of the predetermined frequency is applied to the drive electrode 912A of the piezoelectric actuator 91, it excites an oscillation in a longitudinal primary oscillation mode in which the piezoelectric element 912 advances and retracts along the longitudinal direction. At this time, since the convex portions 914 are provided on both ends of the orthogonal line of the piezoelectric actuator 91, the weight of the entire piezoelectric actuator 91 becomes unbalanced with respect to the central line in the longitudinal direction. Due to the unbalance, the piezoelectric actuator 91 excites the oscillation in the flexural secondary oscillation mode creating flexural oscillation in a direction substantially perpendicular to the longitudinal direction of the oscillating member 66. As a result, the piezoelectric actuator 91 excites oscillation that combines the oscillation in the longitudinal primary oscillation mode and the oscillation in the flexural secondary oscillation mode, and the convex portion 914 oscillates while describing a substantially elliptical path.

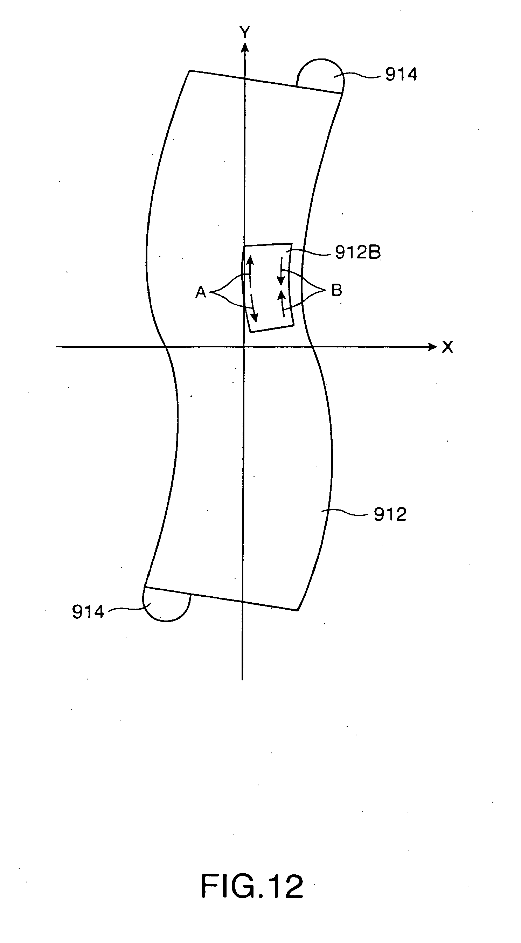

As shown in Fig. 12, the expanding parts (arrows A) and the contracting parts (an arrows B) occur in the detection electrode 912B due to the flexural secondary oscillation mode. The piezoelectric elements generate positive charges at the time of being contracted and generate negative charges at the time of being expanded. By using that, when signal is detected from the detection electrode 912B, charges in accordance with the expansion and the contraction of the detection electrode 912B are so generated that signals corresponding to the oscillation are obtained.
That is, when the piezoelectric element 912 is contracted by giving signal to the drive electrode 912A, in the longitudinal primary oscillation mode, it is determined whether the detection electrode 912B is expanded or contracted in any time.
On the other hand, in the flexural secondary oscillation mode, the expanding parts and the contracting parts may concurrently occur in some locations of forming the detection electrode 912B. In the detection electrode 912B where the expanding parts and the contracting parts concurrently occur, the positive and negative charges are offset each other, and then the detected signal decreases. According to this, the phase difference of the drive signal and the detection signal near the resonance frequency decreases as well.
Accordingly, in the detection electrode 912B where the expanding and contracting parts due to the flexural secondary oscillation mode concurrently occur, the electric charges are offset by expanding and contracting respectively. Further, the phase difference due to the flexural secondary oscillation mode is almost zero, for example, low value of 20° or less.

In this case, when the location of X axis direction of the detection electrode 912B moves to the backward direction, that is, to the Y axis, the phase difference due to the flexural secondary oscillation mode increases. Further, when the location of the X axis direction of the detection electrode 912B moves to the forward direction, that is to the cross section of the piezoelectric element 912, the phase difference due to the flexural secondary oscillation mode becomes a negative value. Generally, detection is controlled in the phase difference of 0° to 180°, but since detection should be controlled in the phase difference of -180° to +180°, a control processing apparatus becomes complex. Therefore, it is necessary for the location of X axis direction of the detection electrode 912B to be disposed within the appropriate range between Y axis and the edge of the piezoelectric element (for example, between A and B in Fig. 11).
In addition, when the location of Y axis direction of the detection electrode 912B moves to the forward direction of Y axis, that is, to the longitudinal direction end of the piezoelectric element 912, the phase difference due to the flexural secondary oscillation mode increases and the level of the detection signal decreases. That is, when the detection electrode 912B moves to the forward direction of Y axis, strain by the longitudinal primary oscillation mode decreases, and thus electric charges generated by the strain decrease and the level of the detection signal also decreases. In the embodiment, since the detection signal generated in the detection electrode is used for control, when the level of the signal is low, the signal is easily affected by electric noise, mechanical oscillation, or light impact, and thus the control may be unstable.
Further, the ratio of the electric charge generated by the strain of the flexural secondary oscillation mode becomes increased. As a result, since the effect of the flexural oscillation becomes strong, the phase difference due to the flexural secondary oscillation mode becomes huge.
Accordingly, it is necessary for the location of Y axis direction of the detection electrode 912B to be disposed within the predetermined range between X axis and the end of the longitudinal direction of the piezoelectric element (for example, between A and C in Fig. 11).

The drive electrode 912A, the detection electrode 912B, and the reinforcing plate 911 are all connected to a voltage applying device (not shown) by a leading line or the like. The voltage application apparatus controls the drive signal so that the phase difference between the drive signal and the detection signal reaches a suitable value, similar to the voltage applying device 84 in the first embodiment.

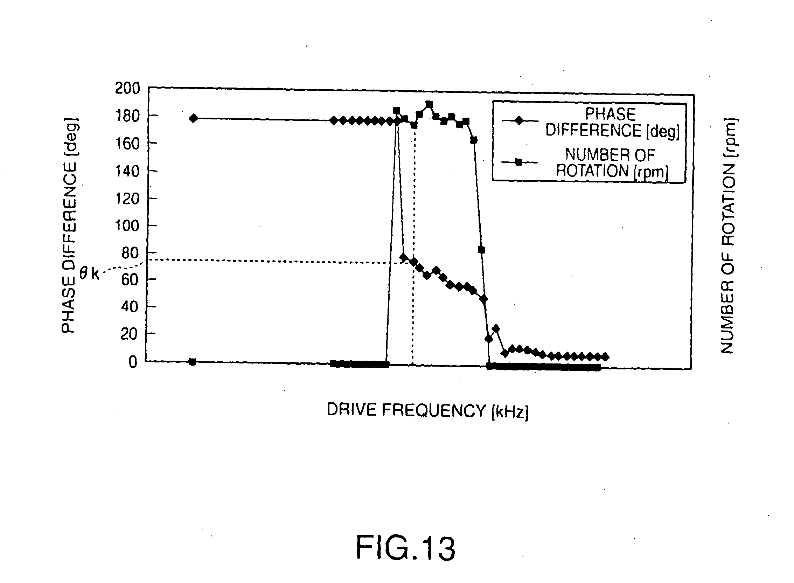

Fig. 13 is a diagram showing an oscillation characteristic of the piezoelectric actuator 91 and an operation characteristic of the date display mechanism 90 with respect to the drive frequency applied to the piezoelectric actuator 91 in the date display mechanism 90 according to the embodiment. In Fig. 13, the phase difference with respect to the drive frequency gradually decreases as the drive frequency increases in a range of a predetermined drive frequency. Further, it can be understood that the number of rotations of the rotor 92 with respect to the drive frequency increases in a range of a drive frequency in which the phase difference decreases. That is, the range of the drive frequency means a range of a drive frequency which is between the resonance frequency of the oscillation in the longitudinal primary oscillation mode and the resonance frequency of the oscillation in the flexural secondary oscillation mode, and in which the oscillation modes are preferably implemented at the same time. Accordingly, in the present embodiment, the reference phase difference signal Vk of the voltage applying device is set to a predetermined value that has a voltage value corresponding to the phase difference θk (for example, in a range of 70 to 80 degrees) corresponding to the range of the drive frequency.
A plate spring 922 is mounted on the rotor 92, and the rotor 92 is urged toward the piezoelectric actuator 91. As a result, an appropriate frictional force is generated between the convex portions 914 and the side of the rotor 92, resulting in efficient transmission of the drive force of the piezoelectric actuator 91.

In the above-described timepiece 9, the voltage applying device controls the drive signal for the piezoelectric actuator 91 in the same manner as in the first embodiment, and a drive signal of a predetermined frequency is applied. In this case, the piezoelectric actuator 91 excites an oscillation that combines a longitudinal primary oscillation mode and a flexural secondary oscillation mode. The convex portions 914 oscillate while describing a substantially elliptical path that combines these oscillation modes and the rotor 92 is pressurized along a part of this oscillation path. As a result, the rotor 92 is rotatably driven.
The rotational movement of the rotor 92 is transmitted to the date turning intermediate wheel 94, and when the teeth of the date turning wheel 95 engage with the notch 943. In this case, the date turning wheel 95 is rotated by the date turning intermediate wheel 94, which rotates the date wheel 93. The date displayed by the date wheel 93 is changed as a result of this rotation.

According to the second embodiment, the structure of the second embodiment is different from that of the first embodiment, but the following effects are obtained, in addition to the same effects as in (1), (2), and (4) of the first embodiment. (6) Since the convex portions 914 are provided at both ends of the diagonal line of the piezoelectric actuator 91, a flexural secondary oscillation mode can be induced, in addition to the longitudinal primary oscillation mode due to the weight unbalance merely by providing a single drive electrode 912A. Therefore, the configuration of the electrodes in the piezoelectric element 912 can be simplified. Accordingly, the process of controlling the drive signal with the voltage applying device can also be simplified. This arrangement is particularly advantageous when, for example, the piezoelectric actuator 91 is compact because it is difficult to form electrodes with complicated shapes by using grooves in a small-sized piezoelectric element 912.

(7) Since the piezoelectric actuator 91 is used in the date display mechanism 90 of the timepiece 9, the drive efficiency of the piezoelectric actuator 91 is always optimally controlled. Therefore, the reliability of driving the date display mechanism 90 can be improved, and the date can be accurately displayed. Further, the timepiece 9 can be made compact by reducing the size of the piezoelectric actuator 91.

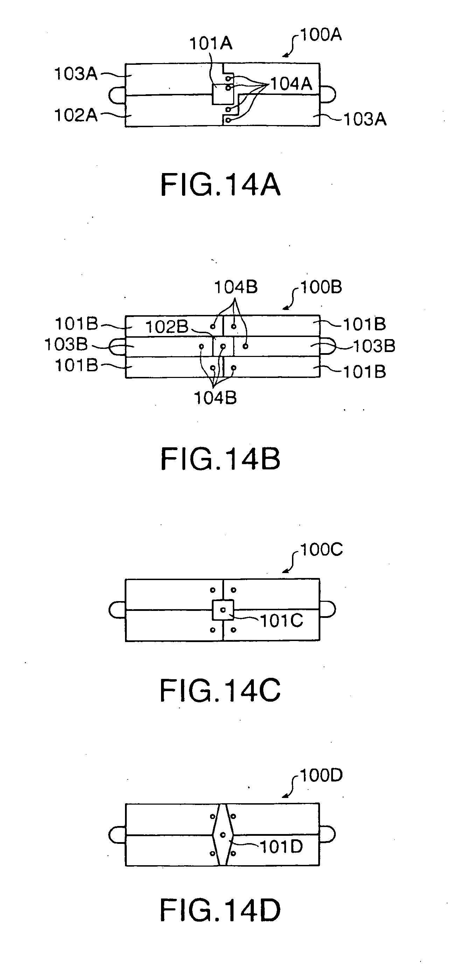

The present invention is not limited to the above-described embodiments, and various modifications, improvements, and the like can be included in the invention within a range in which the objects of the present invention can be achieved.
As for the shapes, arrangement, and the like of the detection electrodes, the detection electrodes are formed in a substantially rhombus shape at the center of the piezoelectric element 82 in the first embodiment, and the detection electrodes are formed in a substantially rectangular shape to be closer to the convex portion 914 of the piezoelectric element 912 in the second embodiment. However, the present invention is not limited thereto. For example, the detection electrodes may be configured according to the shape and the arrangement shown in Figs 14A to 14F.
In the piezoelectric actuator 100A shown in Fig. 14A, the detection electrode 101A that has substantially a square shape is formed at substantially the center of the surface of the piezoelectric element. Further, at a part of the surface of the piezoelectric element other than the detection electrode 101A, a pair of rectangular drive electrodes 102A and 103A are formed at both sides on the diagonal line. Between the drive electrodes 102A and 103B, the drive electrodes 102A are connected to each other at substantially the center of the piezoelectric element, thereby forming a single drive electrode 102A. Accordingly, in the piezoelectric actuator 100A, three drive electrodes 102A and 103A, and one detection electrode 101A are formed. Further, in this case, the lead line connecting location portions 104A to which the lead lines are connected are formed at the drive electrodes 102A and 103A, and the detection electrode 101A. In the drive electrodes 102A and 103A, the irregularities are formed near the center of the piezoelectric element in the longitudinal direction, and thus the lead line connecting location portions 104A are disposed in almost one line near the center of the piezoelectric element in the longitudinal direction. By this arrangement, the lead lines may be easily connected to the respective electrodes. Further, since the drive electrodes 102A are connected to each other near the center of the piezoelectric element, the number of the leading lines that are connected to the piezoelectric element can be reduced, which simplifies a structure of the piezoelectric actuator 100A.

In the piezoelectric actuator 100B shown in Fig. 14B, the electrodes are divided into three parts along the longitudinal direction of the piezoelectric element. Among the electrodes, at the electrodes at both ends of the piezoelectric actuator 100B, the electrodes are divided into two parts along the transverse direction, and as a result of it, the four drive electrodes 101B are formed. Further, at the middle electrode, the substantially square detection electrode 102B is formed at substantially the center of the piezoelectric element, and the drive electrodes 103B are formed at both sides. If the voltage is applied to the drive electrodes 101B at both ends on the diagonal line among the drive electrodes 101B and the drive electrode 103B, the piezoelectric actuator 100B excites an oscillation that combines the oscillation in the longitudinal primary oscillation mode and the oscillation in the flexural secondary oscillation mode. Further, it is preferable that the leading line connecting location portions 104B be mainly formed at substantially the center of the piezoelectric element. Since the substantial center of the piezoelectric element may correspond to the node of the oscillation in the longitudinal primary oscillation mode and the node of the oscillation in the flexural secondary oscillation mode, the variation width of the piezoelectric actuator 100B is decreased, which prevents the leading lines from being disconnected.

In the piezoelectric actuator 100C shown in Fig. 14C, at the same locations as the detection electrodes 82C according to the first embodiment, the detection electrodes 101C that have substantially a square shape are formed.
Further, in the piezoelectric actuator 100D shown in Fig. 14D, the detection electrodes 101D are formed in a polygonal shape (hexagonal shape).
As described above, the detection electrodes may have various arbitrary shapes, such as a circular shape, an elliptical shape, a varied shape, and the like, in addition to the substantially square shape and the polygonal shape.

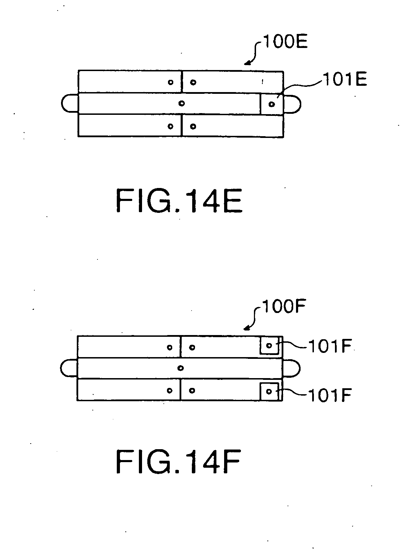

The arrangement locations of the detection electrodes are not limited to the locations including the node of the oscillation in the longitudinal primary oscillation mode and the node of the oscillation in the flexural secondary oscillation mode. For example, as shown in Fig. 14E, the detection electrodes may be formed at the locations including the node of the oscillation in the flexural secondary oscillation mode, except for the node of the oscillation in the longitudinal primary oscillation mode. When the piezoelectric actuator is operated while mainly using the longitudinal primary oscillation mode, the detection electrodes may be formed at the locations including the node of the oscillation in the oscillation mode other than the longitudinal primary oscillation mode, for example, node of the oscillation in the flexural secondary oscillation mode, if necessary
Further, the arrangement locations of the detection electrodes are not limited to the locations including the node of the oscillation in the flexural secondary oscillation mode. For example, when the piezoelectric actuator is operated while mainly using the oscillation in the flexural secondary oscillation mode, the detection electrodes may be formed at the locations including the node of the oscillation in the oscillation mode other than the flexural secondary oscillation mode. That is, when the piezoelectric actuator is operated while mainly using the oscillation in the flexural secondary oscillation mode, for example, like the detection electrodes 101E shown in Fig. 14E or the detection electrodes 101F shown in Fig. 14F, the detection electrodes may be formed at both ends of the piezoelectric element in a longitudinal direction. That is, the detection electrodes 101F may be formed at the locations including the locations where the strain due to the oscillation in the longitudinal primary oscillation mode becomes minimized.
For example, the detection electrodes may be formed at the locations including the locations where the strain due to the oscillation in the oscillation mode other than the mainly used oscillation mode becomes so minimized that the phase difference due to the oscillation mode other than the mainly used oscillation mode becomes less than the target phase difference.
Further, the detection electrodes may be formed at the locations including the locations where the strain becomes minimized, without the locations where the strain due to the oscillation in the oscillation mode other than the mainly used oscillation mode becomes minimized limited to the locations corresponding to the centroid of the shapes of the detection electrodes.
Even when the convex member 81A is disposed on Y axis like the first embodiment and does not become unbalanced, the expanding and contracting parts due to the oscillation of the oscillation mode other than the mainly used oscillation mode concurrently occur, the detection electrodes are disposed in the location where the electric charges generated in each part are offset each other, and the detection electrodes may be formed at the location including the location where the phase difference due to the oscillation mode other than the mainly used oscillation mode is less than the target phase difference.

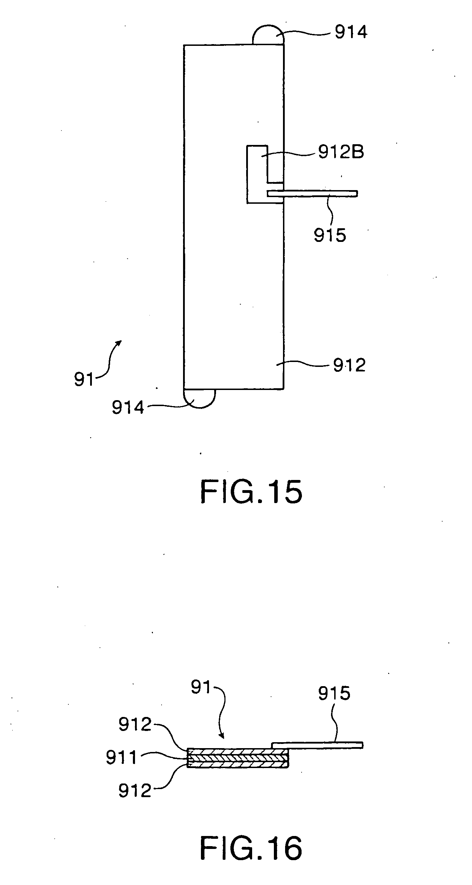

The shape of the detection electrode 912B formed at location where the expansion and contraction parts concurrently occur is limited to the rectangular (a quadrangle) as the same as the second embodiment. For example, a plain L-shape may be formed as shown in Fig. 15. In effect, the detection electrode 912B is disposed at location where the positive and negative charges generated are offset, and the shape is not limited specifically.
When a part of the detection electrode 912B is expanded to the end of the piezoelectric element 912 as shown Fig.15, it is advantageous that the structure of the arrangement is simplified. That is because the arrangement line 915 such as the lead line and the like is expanded from the side of the piezoelectric element 912, so as to connect to the detection electrode 912B.

The oscillation mode is not limited to the longitudinal primary oscillation mode or the flexural secondary oscillation mode, and any other oscillation modes, such as a longitudinal secondary oscillation mode or a flexural primary oscillation mode, can be employed. Further, the piezoelectric actuator is not limited to having two oscillation modes, and may also have three or more oscillation modes. In this case, the detection electrodes may be formed at the locations including the locations where the strain due to the oscillation in the oscillation mode other than the mainly used oscillation mode becomes minimized. When the number of the oscillation modes is three or more, the detection electrodes may be formed at the locations including the locations where the strain due to the oscillation in the oscillation mode having the largest influence on the detection signals among the oscillation modes other than the mainly used oscillation mode becomes minimized. Alternatively, the detection electrodes may be formed at the locations including the locations where the strain due to the oscillation in the oscillation mode in which the detection patterns of the detection signals are similar to those in the mainly used oscillation mode, selected from among the oscillation modes other than the mainly used oscillation mode, becomes minimized.

The initial value Vf1 has been set to the upper limit of a preset adjustment range for the drive frequency. However, the present invention is not limited thereto, and the initial value Vf1 may be set to the lower limit of the adjustment range of the drive frequency, for example. Even in this case, since the drive frequency corresponding to the phase difference is determined to a single value, the drive frequency applied to the piezoelectric actuator can be optimally controlled, when the phase difference is controlled with a predetermined value.

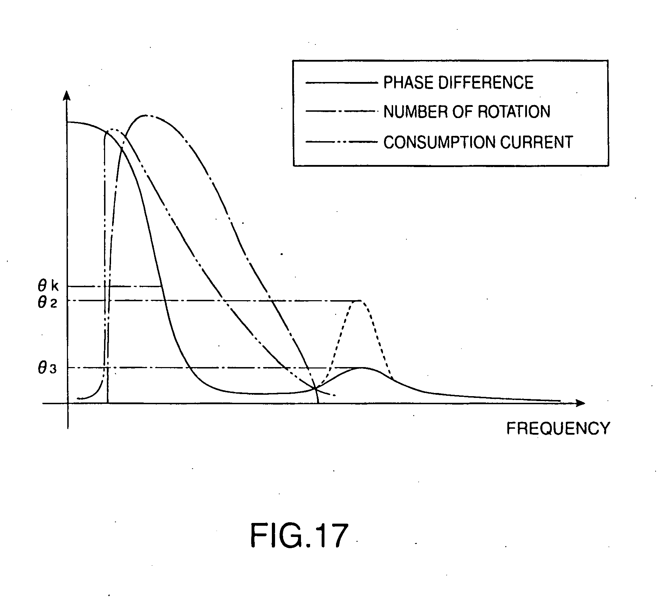

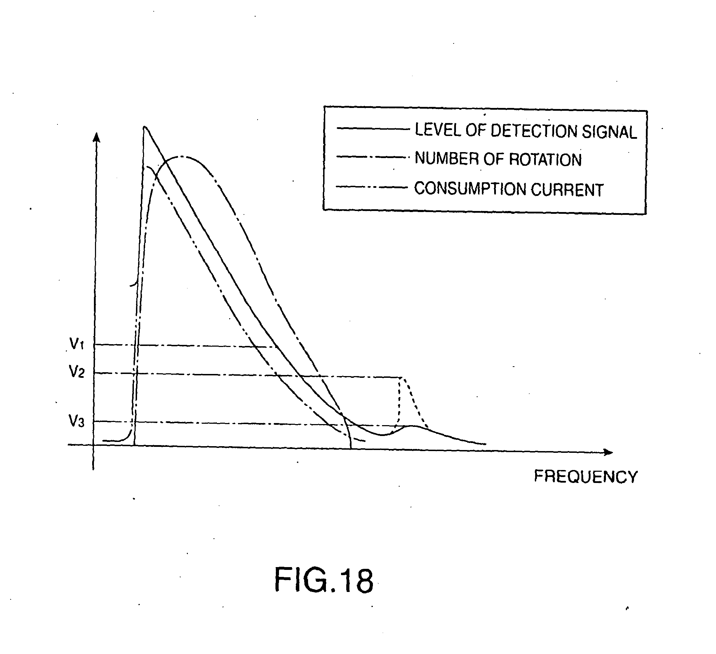

In each of the embodiments, the drive frequency is controlled on the basis of the phase difference of the drive signal and the detection signal, and the drive frequency may be controlled on the basis of a level of the detection signal.
That is, as shown in Fig.17, when the drive frequency is controlled on the basis of the phase difference in each of the embodiments, for example, the predetermined target phase difference θk is set when the number of rotation is the highest, and the drive frequency is adjusted to a frequency of which a value of the phase difference becomes the target phase difference θk, and at the same time, the detection electrode may be formed at the location where a phase difference due to the flexural secondary oscillation mode is less than the target phase difference θk. That is, the detection electrode may be formed so that the phase difference θk and the like due to the flexural secondary oscillation mode is less than the target phase difference θk, and more preferably the detection electrode may be formed at the location where the phase difference is 20° or less, like a phase difference θ₃ due to the flexural secondary oscillation mode.
On the other hand, as shown Fig. 18, since the level of the detection signal is a function of the number of the rotation and the consumption electricity as the same as the phase difference, the drive frequency can be controlled on the basis of the level of the detection signal. That is, the drive frequency may be controlled so that the level of the detection signal due to the longitudinal primary oscillation mode becomes the target level V₁. In this case, the detection electrode may be formed so that the level of the detection signal (for example, V₂) due to the flexural secondary oscillation mode becomes less than the target level V₁, and more preferably, the detection electrode may be formed at the location where the level of the detection signal becomes almost zero, like the level of the detection signal V₃ due to the flexural secondary oscillation mode.

The preferred configurations, methods, and other aspects employed in order to carry out the present invention are disclosed in the above descriptions, but the invention is not limited thereto. Specifically, the invention is particularly illustrated and described primarily with reference to specific embodiments, but those skilled in the art can make various modifications to the shapes, materials, quantities, and other specific details of the embodiments described above without deviating from the scope of the technical ideas and objects of the invention.
Therefore, the descriptions that are disclosed above and refer to specific shapes, materials, and other aspects are given solely with the intent of making the invention easy to understand and are not intended to limit the invention. For this reason, descriptions that contain names of members in which some or all of the limitations on shapes, materials, and other items have been removed are also included in the invention.

### Example 1

The following experiments are conducted in order to confirm the effects of the invention.

### [Example 1]

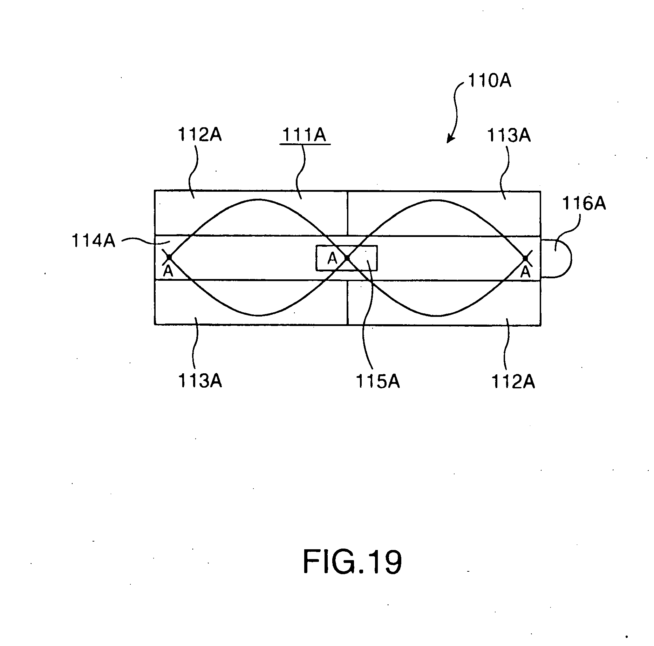

A simulation is performed using a piezoelectric actuator 110A shown in Fig. 19. On the plating layer of the surface of the piezoelectric element 111A of the piezoelectric actuator 110A, a plurality of electrodes, which are electrically insulated from each other through the cut-out grooves, are formed in linear symmetry with the central line along the longitudinal direction used as an axis. That is, two grooves are formed such that the piezoelectric element 111A is divided into three substantially equal parts in a widthwise direction (transverse direction). Among the three electrodes divided by these grooves, grooves are formed at the opposite electrodes such that the longitudinal direction is divided into two parts to be substantially equal to each other. By means of these grooves, the five electrodes are formed on the surface of the piezoelectric element 111A. Among the five electrodes, the two electrodes formed at both sides on the diagonal line become the drive electrodes 112A and 113A, and the central electrode becomes the drive electrode 114A. At substantially the center of the piezoelectric element 111A, in the drive electrode 114A, the detection electrode 115A having substantially a rectangular shape is formed. The drive electrodes 112A, 113A, and 114A, and the detection electrode 115A are connected to the same voltage applying device as the first embodiment. If the drive signals are applied to the drive electrodes 112A and 114A, the piezoelectric actuator 110A excites the oscillation that combines the oscillation in the longitudinal primary oscillation mode and the oscillation in the flexural secondary oscillation mode, and the convex portion 116A oscillates while describing a substantially elliptical path. Further, if the drive signals are applied to the drive electrodes 113A and 114A, the oscillation direction in the flexural secondary oscillation mode becomes an opposite direction, and the convex portion 116A oscillates while describing a substantially elliptical path in a reversed direction. Accordingly, the node of the oscillation in the longitudinal primary oscillation mode becomes a central point A of the piezoelectric actuator 110A, and the node of the oscillation in the flexural secondary oscillation mode become three points A along the longitudinal direction of the piezoelectric actuator 110A. That is, the detection electrodes 115A are formed at the locations including the locations of the node of the oscillation in the longitudinal primary oscillation mode and the node of the oscillation in the flexural secondary oscillation mode.
In a state where the convex portion 116A of the piezoelectric actuator 110A comes into contact with the side surface of the rotor, and the drive frequency of the drive signal is varied, the relationship between each drive frequency and the rotational speed of the rotor is investigated. Further, the relationship of the phase difference between the drive signal and the detection signal with respect to the each drive frequency is investigated.

### [Comparative Example 1]

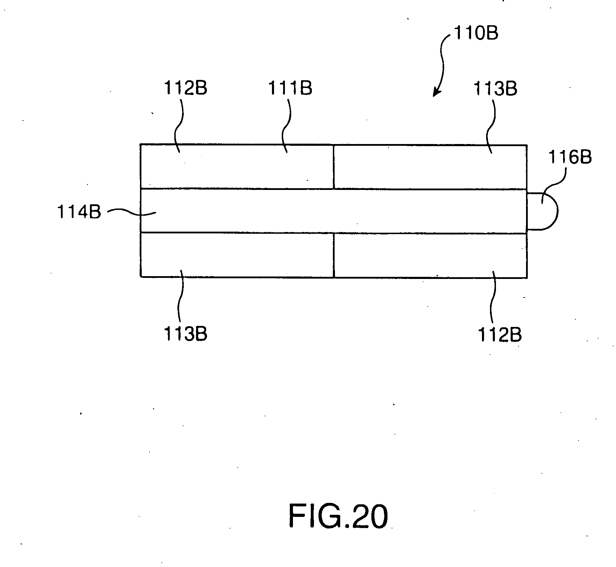

A simulation is performed using a piezoelectric actuator 110B shown in Fig. 20. Five drive electrodes 112B, 113B, and 114B are formed on the surface of the piezoelectric element 111B of the piezoelectric actuator 110B in the same manner as the piezoelectric actuator 110A of the embodiment. Of the two drive electrodes 113B, the one farther from the convex portion 116B is used as the detection electrode when a drive signal is inputted to the drive electrodes 112B. Of the two drive electrodes 112B, the one farther from the convexity 116B is used as the detection electrode, when a drive signal is inputted to the drive electrodes 113B.
All other conditions are similar to those of the embodiment.

### [Result of Example 1 and Comparative Example 1]

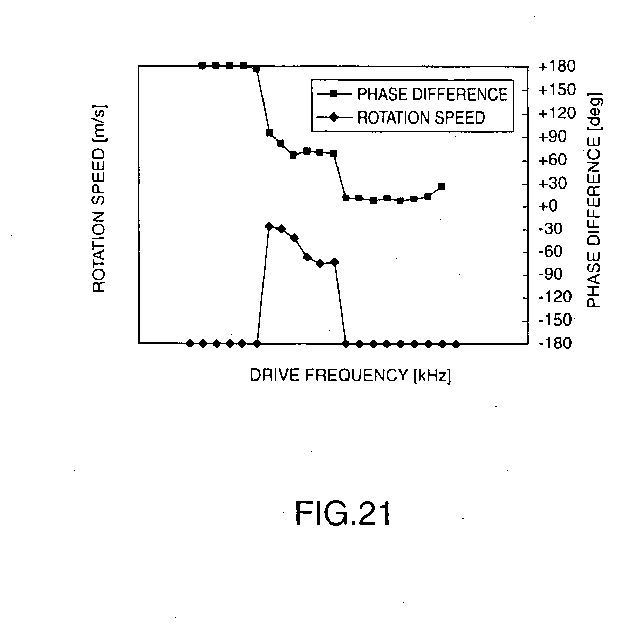

Fig. 21 shows the results of the embodiment. As shown in Fig. 21, it can be understood that the rotational speed of a rotor with respect to the drive frequency increases in a predetermined range, and is zero in the other range, that is, the rotor does not rotate. Accordingly, it can be understood that if the drive signal is adjusted in a range of a drive frequency, the rotational speed of the rotor can be sufficiently ensured. Further, the phase difference with respect to the drive frequency becomes 180° at a drive frequency that is lower than a lower limit of a range of a drive frequency in which the rotational speed of the rotor increases. However, at the drive frequency higher than the drive frequency, the phase difference gradually decreases as the drive frequency increases. At the drive frequency that is higher than the upper limit of a range of a drive frequency in which the rotational speed of the rotor increases, the phase difference is in a range of about 0 to 30°. Accordingly, in the piezoelectric actuator 110A according to the embodiment, since the phase difference gradually decreases with the drive frequency increased, if the phase difference is controlled by appropriately setting it to a range of 70 to 80°, the rotational speed of the rotor can be appropriately ensured. In this case, it can be understood that the drive frequency with respect to the phase difference is determined to a single value.

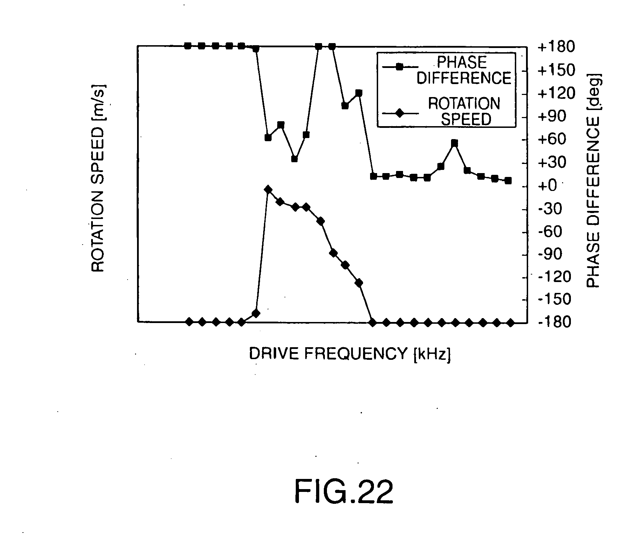

Meanwhile, Fig. 22 shows the results of the comparative example. As shown in Fig. 22, it can be understood that the rotational speed of a rotor with respect to the drive frequency increases in a predetermined range, similar to the embodiment, and in the range of the drive frequency, the phase difference with respect to the drive frequency decreases near the lower limit in the range of the drive frequency, but if the drive frequency increases, the phase difference increases again to become about 180°, and decreases again. That is, even when the phase difference is controlled by setting it to a predetermined value in a range of 70 to 80°, drive frequencies with respect to one phase difference are three. Accordingly, the drive frequency may be set to any one of three drive frequencies, and it may be a drive frequency that is capable of ensuring an appropriate rotational speed of the rotor. When the drive frequency becomes other drive frequency, the rotational speed of the rotor cannot be appropriately maintained, which lowers the reliability of a rotational drive performance of the rotor.

As described above, it can be confirmed that the drive frequency with respect to the phase difference can be determined to a single value, and the phase difference between the drive signal and the detection signal can be controlled to a predetermined value, so that the piezoelectric actuator can always oscillate with the optimal drive frequency.

### Example 2

The following experiments of variation of phase differences and detection signal levels are conducted when locations of the detection electrode 912B are changed by using the above piezoelectric actuator

### [Example 2]

The piezoelectric actuator 91 shown in Fig. 11 is used to conduct an experiment. In the piezoelectric element 912 of the piezoelectric actuator 91, L₁ is equal to 1.98mm and L₂ is equal to 7.0mm. The detection electric 912B is formed in the shape of a rectangular square where A'(X, Y) is (0.595, 0.15), B'(X, Y) is (0.891, 0.15), C'(X, Y) is (0.595, 1.73), and D' (X, Y) is (0.819, 1.73).
Further, the convex portion 914 of the piezoelectric actuator 91 comes into contact with the side surface of the rotor. The drive frequency of the drive signal is varied so that relationship of the phase difference showing variation of the drive signal and the detection signal with respect to each the drive frequency is investigated and the relationship of the detection signal showing variation of the level of the detection signal is investigated. Graphs showing characteristics of the phase difference and the detection signal are shown in Figs, 23 and 24.

### [Comparative Example 2]

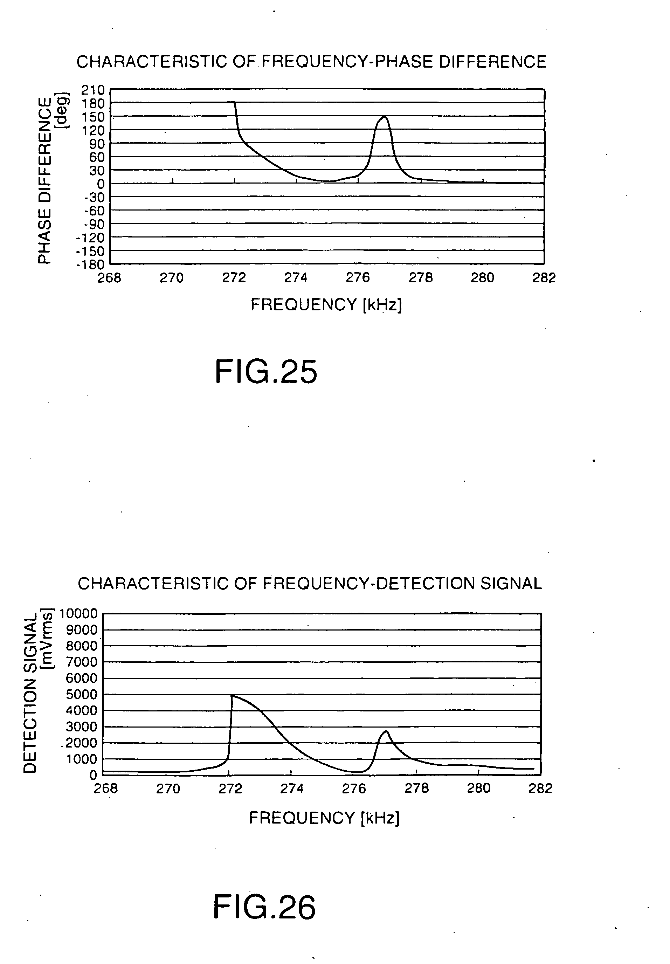

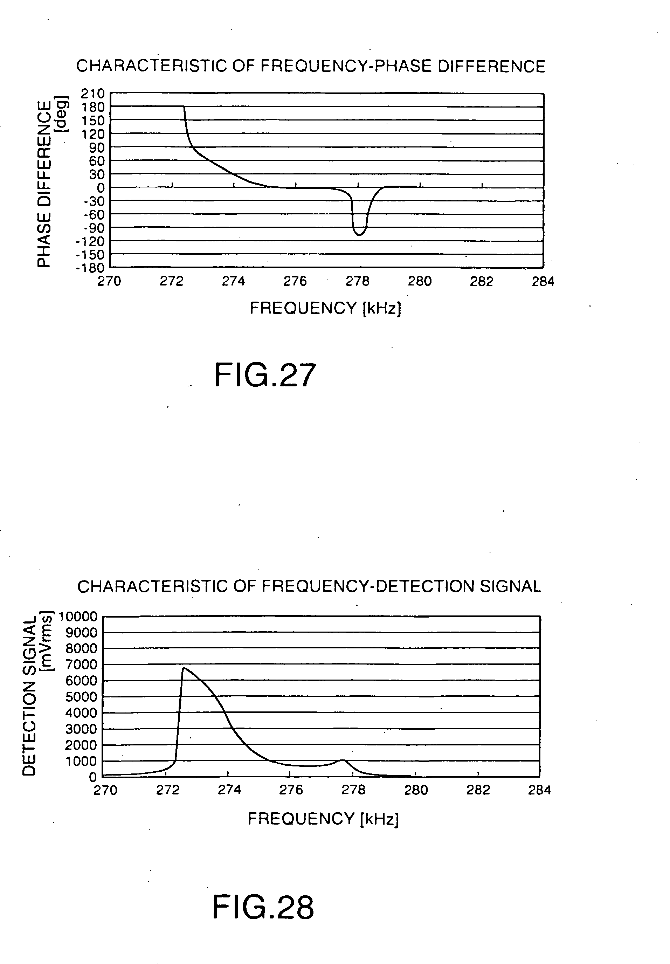

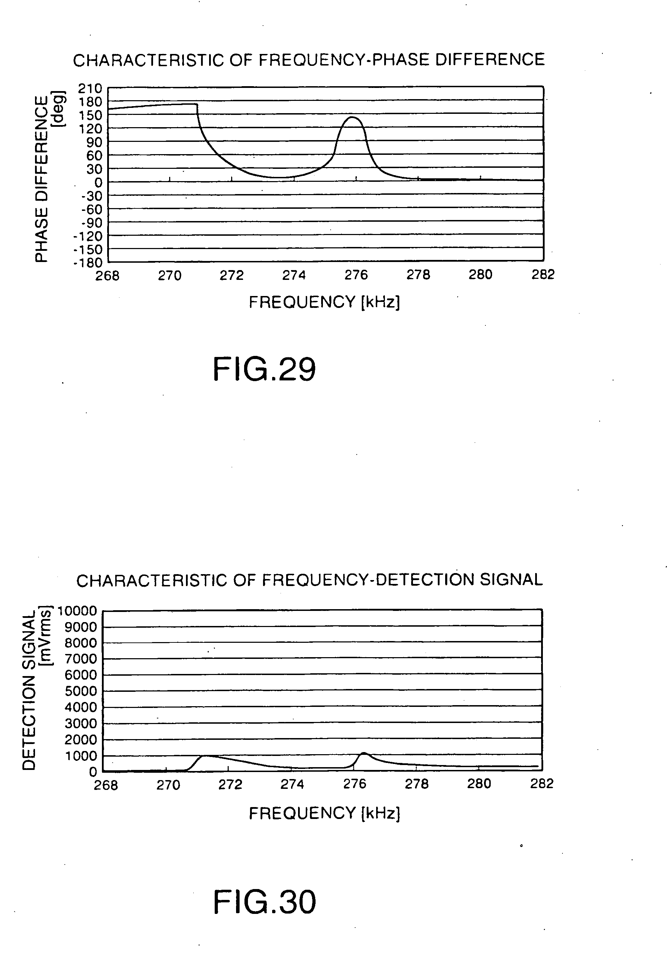

On the other hand, when the detection signal 912B moves to the backward direction of X axis more than an area ABCD to be formed, moves to the forward direction of X axis, and moves to the forward direction of Y axis, the characteristics of the phase difference and detection signal are investigated. Figs. 25 and 26 are graphs showing the characteristics of the phase difference and the detection signal when the detection signal 912B moves to the backward direction of X axis. Figs. 27 and 28 are graphs showing the characteristics of the phase difference and the detection signal when the detection signal 912B moves to the forward direction of X axis. Fig. 29 and 30 are graphs showing the characteristics of the phase difference and the detection signal when the detection signal 912B moves to the forward direction of Y axis.

### [Result of Example 2 and Comparative Example 2]

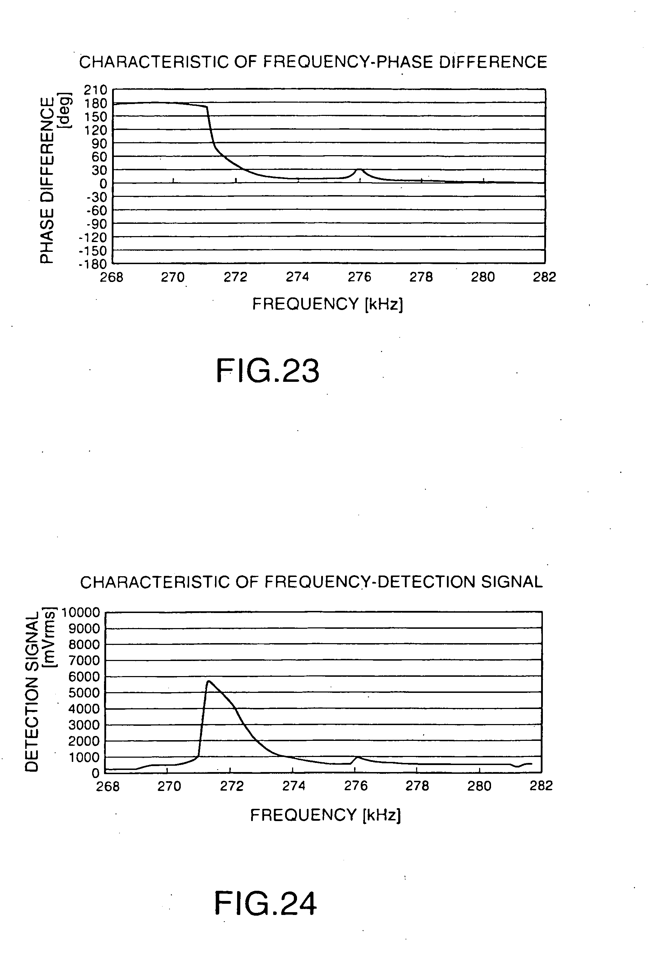

As shown in Figs. 23 to 30, when the detection electrode 912B is formed in the predetermined area ABCD, the signal of the phase difference due to the flexural secondary oscillation mode decreases. Accordingly, when the target phase difference is set, it is understood that the drive frequency is determined to the single value.
On the other hand, when the detection electrode 912B moves from the area ABCD in the backward direction of X axis or the forward direction of Y axis to be formed, the signal of the phase difference due to the flexural secondary oscillation mode increases. Accordingly, when the target phase difference is set, there are two drive frequencies, and accordingly, it is understood that the frequency can be driven with drive characteristic deteriorated.

With respect to the level of the detection signal, when the detection electrode 912B is formed in the predetermined area ABCD, sufficient level of the signal is generated. However, when the detection electrode 912B moves to the backward direction of X axis to be formed, relatively high level of the signal due to the flexural secondary oscillation mode is generated. Accordingly, when the drive frequency is controlled on the basis of the level of the detection signal, it is understood that there is a problem. When the detection electrode 912B moves to the forward direction of Y axis to be formed, the level of the detection signal seriously decreases. Accordingly, when the drive frequency is controlled on the level of the detection signal, it is understood that there is a problem.

As described above, it can be confirmed that when the detection electrode 912B is formed at the location
where the expansion parts and the contraction parts due to the flexural secondary oscillation mode concurrently occur, and thus electric charges generated in each part are offset, the drive frequency can be determined to a single value, and the phase difference of the drive signal and the detection signal or the level of the detection signal is controlled to a predetermined value, so that the piezoelectric actuator can always oscillate with the optimal drive frequency.

### Industrial Applicability

The present invention is applicable to a piezoelectric actuator that drives driven members by oscillating piezoelectric elements and an apparatus including the piezoelectric actuator.

## Claims

1. A piezoelectric actuator (66) that drives a driven member (30) by oscillating a piezoelectric element (82) having two or more oscillation modes, the piezoelectric actuator comprising:
a drive electrode (82A, 82B) that applies a drive signal to the piezoelectric element so as to oscillate the piezoelectric element;
a detection electrode (82C) that detects an oscillation behavior of the piezoelectric element;
a control unit (84) that controls the drive signal (Vh) on the basis of the phase difference between the drive signal applied to the drive electrode and a detection signal (Va) detected by the detection electrode,
**characterized in that**
the detection electrode is formed at a location where a phase difference (θ) due to an oscillation mode other than the mainly used oscillation mode is less than a target phase difference (θk) at the time of controlling, and **in that**
the control unit is configured to control and hold the phase difference near the target phase difference.

2. The piezoelectric actuator according to claim 1,wherein the detection electrode is formed at a location where the phase difference due to the oscillation mode other than the mainly used oscillation mode is less than 20 deg.

3. The piezoelectric actuator according to claim 1 or 2, wherein the detection electrode is formed at a location where an expansion part and a contraction part due to the oscillation mode other than the mainly used oscillation mode occur concurrently, and thus electric charges generated in each of the parts are offset.

4. The piezoelectric actuator according to claim 1 or 2, wherein the detection electrode is formed at a location including a location where strain due to the oscillation mode other than the mainly used oscillation mode becomes minimized.

5. The piezoelectric actuator according to claim 4, wherein the oscillation mode includes a longitudinal oscillation mode in which the piezoelectric element expands and contracts in a predetermined direction, and a flexural oscillation mode in which flexural oscillation is created in a direction substantially perpendicular to an oscillation direction of the longitudinal oscillation mode, and
wherein the detection electrode is formed at a location including a node of an oscillation in the flexural oscillation mode.

6. The piezoelectric actuator according to claim 4 or 5,
wherein the piezoelectric element is formed substantially in a rectangular shape,
wherein the oscillation mode includes a longitudinal primary oscillation mode in which the piezoelectric element expands and contracts along a longitudinal direction of the piezoelectric element, and a flexural secondary oscillation mode in which flexural oscillation is created in a direction substantially perpendicular to an oscillation direction of the longitudinal primary oscillation mode, and
wherein the detection electrode is formed at a location including a node of an oscillation in the longitudinal primary oscillation mode and a node of an oscillation in the flexural secondary oscillation mode.

7. The piezoelectric actuator according to any one of claims 1 to 6, wherein the piezoelectric actuator is capable of switching oscillation direction of the flexural oscillation mode between the forward and backward directions.

8. The piezoelectric actuator according to any one of claims 1 to 7, wherein an area of the detection electrode is 1/30th or more and 1/7th or less of an area of the drive electrode.

9. An apparatus comprising the piezoelectric actuator according to any one of claims 1 to 8.

10. The apparatus according to claim 9, further comprising:
a lens (30, 40, 50); and
a drive unit (1) that drives the lens by oscillating the piezoelectric actuator.

11. The apparatus according to claim 9,
wherein the apparatus is a timepiece (9) that is driven by oscillating the piezoelectric actuator.

## Patentansprüche

1. Piezoelektrischer Aktuator (66), der ein angetriebenes Element (30) durch in Schwingung versetzen eines piezoelektrischen Elements (82) antreibt, das zwei oder mehr Schwingungsmoden aufweist, wobei der piezoelektrische Aktuator umfasst:
eine Antriebselektrode (82A, 82B), welche ein Antriebssignal so an das piezoelektrische Element anlegt, dass das piezoelektrische Element in Schwingung versetzt wird;
eine Detektionselektrode (82C), welche ein Schwingungsverhalten des piezoelektrischen Elements detektiert;
eine Steuereinheit (84), welche das Antriebssignal (Vh) auf der Basis der Phasendifferenz zwischen dem Antriebssignal, das an die Antriebselektrode angelegt wird, und einem Detektionssignal (Va), das von der Detektionselektrode detektiert wird, steuert,
**dadurch gekennzeichnet, dass**
die Detektionselektrode an einem Ort ausgebildet ist, wo eine Phasendifferenz (θ) aufgrund einer Schwingungsmode, die sich von der hauptsächlich verwendeten Schwingungsmode unterscheidet, kleiner ist als eine Zielphasendifferenz (θk) zur Zeit der Steuerung, und dadurch, dass
die Steuereinheit aufgebaut ist, um die Phasendifferenz nahe an der Zielphasendifferenz zu steuern und zu halten.

2. Piezoelektrischer Aktuator nach Anspruch 1, bei dem die Detektionselektrode an einem Ort ausgebildet ist, wo die Phasendifferenz, aufgrund der Schwingungsmode, die sich von der hauptsächlich verwendeten Schwingungsmode unterscheidet, kleiner als 20 deg ist.

3. Piezoelektrischer Aktuator nach Anspruch 1 oder 2, bei dem die Detektionselektrode an einem Ort ausgebildet ist, wo ein Erweiterungsteil und ein Kontraktionsteil, aufgrund der Schwingungsmode, die sich von der hauptsächlich verwendeten Schwingungsmode unterscheidet, gleichzeitig auftreten, und somit elektrische Ladungen, die in jedem der Teile erzeugt werden, versetzt sind.

4. Piezoelektrischer Aktuator nach Anspruch 1 oder 2, bei dem die Detektionselektrode an einem Ort ausgebildet ist, der einen Ort enthält, wo eine Belastung aufgrund der Schwingungsmode, die sich von der hauptsächlich verwendeten Schwingungsmode unterscheidet, minimiert wird.

5. Piezoelektrischer Aktuator nach Anspruch 4, bei dem die Schwingungsmode eine longitudinale Schwingungsmode enthält, in der sich das piezoelektrische Element in einer bestimmten Richtung erweitert und zusammenzieht, und eine Biegeschwingungsmode, bei der eine Biegeschwingung in einer Richtung im Wesentlichen senkrecht auf einer Schwingungsrichtung der longitudinalen Schwingungsmode erzeugt wird, und
bei dem die Detektionselektrode an einem Ort ausgebildet ist, der einen Knoten einer Schwingung in der Biegeschwingungsmode enthält.

6. Piezoelektrischer Aktuator nach Anspruch 4 oder 5, bei dem das piezoelektrische Element im Wesentlichen rechteckförmig ausgebildet ist,
bei dem die Schwingungsmode eine primäre longitudinale Schwingungsmode, in der sich das piezoelektrische Element entlang einer Längsrichtung des piezoelektrischen Elements erweitert und zusammenzieht, und eine sekundäre Biegeschwingungsmode enthält, bei der eine Biegeschwingung in einer Richtung im Wesentlichen senkrecht auf einer Schwingungsrichtung der primären longitudinalen Schwingungsmode erzeugt wird, und
bei dem die Detektionselektrode an einem Ort ausgebildet ist, der einen Knoten einer Schwingung in der primären longitudinalen Schwingungsmode und einen Knoten einer Schwingung in der sekundären Biegeschwingungsmode enthält.

7. Piezoelektrischer Aktuator nach einem der Ansprüche 1 bis 6, bei dem der piezoelektrische Aktuator imstande ist, die Schwingungsrichtung der Biegeschwingungsmode zwischen den Vorwärts- und Rückwärtsrichtungen umzuschalten.

8. Piezoelektrischer Aktuator nach einem der Ansprüche 1 bis 7, bei dem ein Flächenbereich der Detektionselektrode 1/30stel oder mehr und 1/7tel oder weniger eines Flächenbereichs der Antriebselektrode ist.

9. Vorrichtung, welche den piezoelektrischen Aktuator nach einem der Ansprüche 1 bis 8 umfasst.

10. Vorrichtung nach Anspruch 9, die ferner umfasst:
eine Linse (30, 40, 50); und
eine Antriebseinheit (1), welche die Linse durch in Schwingung versetzen des piezoelektrischen Aktuators betätigt.

11. Vorrichtung nach Anspruch 9, bei der die Vorrichtung eine Uhr (9) ist, welche durch in Schwingung versetzen des piezoelektrischen Aktuators angetrieben wird.

## Revendications

1. Actionneur piézoélectrique (66) qui entraîne un élément entraîné (30) en faisant osciller un élément piézoélectrique (82) ayant deux ou plusieurs modes d'oscillation, l'actionneur piézoélectrique comprenant:
une électrode d'entraînement (82A, 82B) qui applique un signal d'entraînement à l'élément piézoélectrique de manière à faire osciller l'élément piézoélectrique;
une électrode de détection (82C) qui détecte un comportement d'oscillation de l'élément piézoélectrique;
une unité de commande (84) qui commande le signal d'entraînement (Vh) sur la base de la différence de phases entre le signal d'entraînement appliqué à l'électrode d'entraînement et un signal de détection (Va) détecté par l'électrode de détection,
**caractérisé en ce que**
l'électrode de détection est formée à un emplacement où une différence de phases (θ) induite par un mode d'oscillation autre que le mode d'oscillation principalement utilisé est inférieure à une différence de phases (θ) cible au moment de la commande,
et **en ce que**
l'unité de commande est configurée pour commander et maintenir la différence de phases proche de la différence de phases cible.

2. Actionneur piézoélectrique selon la revendication 1, dans lequel l'électrode de détection est formée à un emplacement où la différence de phases induite par un mode d'oscillation autre que le mode d'oscillation principalement utilisé est inférieure à 20 deg.

3. Actionneur piézoélectrique selon la revendication 1 ou 2,
dans lequel l'électrode de détection est formée à un emplacement où une partie de détente et une partie de contraction induites par le mode d'oscillation autre que le mode d'oscillation principalement utilisé se produisent concurremment, et des charges électriques générées dans chacune des parties sont ainsi décalées.

4. Actionneur piézoélectrique selon la revendication 1 ou 2,
dans lequel l'électrode de détection est formée à un emplacement comportant un emplacement où une déformation induite par le mode d'oscillation autre que le mode d'oscillation principalement utilisé est minimisée.

5. Actionneur piézoélectrique selon la revendication 4, dans lequel
le mode d'oscillation comporte un mode d'oscillation longitudinale dans lequel l'élément piézoélectrique se détend et se contracte dans une direction prédéterminée, et un mode d'oscillation de flexion dans lequel une oscillation de flexion est créée dans une direction essentiellement perpendiculaire vers une direction d'oscillation du mode d'oscillation longitudinale, et
où l'électrode de détection est formée à un emplacement comportant un noeud d'une oscillation dans le mode d'oscillation de flexion.

6. Actionneur piézoélectrique selon la revendication 4 ou 5, dans lequel l'élément piézoélectrique est essentiellement de forme rectangulaire,
où le mode d'oscillation comporte un mode d'oscillation primaire longitudinale dans lequel l'élément piézoélectrique se détend et se contracte le long d'une direction longitudinale de l'élément piézoélectrique, et un mode d'oscillation secondaire de flexion dans lequel une oscillation de flexion est créée dans une direction essentiellement perpendiculaire à la direction d'oscillation du mode d'oscillation primaire longitudinale, et
où l'électrode de détection est formée à un emplacement comportant un noeud d'une oscillation dans le mode d'oscillation primaire longitudinale et un noeud d'une oscillation dans le mode d'oscillation secondaire de flexion.

7. Actionneur piézoélectrique selon l'une quelconque des revendications 1 à 6, dans lequel l'actionneur piézoélectrique est capable de commuter une direction d'oscillation du mode d'oscillation de flexion entre les directions vers l'avant et vers l'arrière.

8. Actionneur piézoélectrique selon l'une quelconque des revendications 1 à 7, dans lequel une superficie de l'électrode de détection est 1/30^{ème} ou plus et 1/7^{ème} ou moins d'une superficie de l'électrode d'entraînement.

9. Appareil comprenant l'actionneur piézoélectrique selon l'une quelconque des revendications 1 à 8.

10. Appareil selon la revendication 9, comprenant en plus:
une lentille (30, 40, 50); et
une unité d'entraînement (1) qui entraîne la lentille en oscillant l'actionneur piézoélectrique.

11. Appareil selon la revendication 9,
où l'appareil est un appareil horaire (9) qui est entraîné en faisant osciller l'actionneur piézoélectrique.
